(19) Europäisches Patentamt
European Patent Office
Office européen des brevets

(11) **EP 3 643 104 B2**

(12) **NEUE EUROPÄISCHE PATENTSCHRIFT**
Nach dem Einspruchsverfahren

(45) Veröffentlichungstag und Bekanntmachung des Hinweises auf die Entscheidung über den Einspruch:
**10.09.2025   Patentblatt 2025/37**

(45) Hinweis auf die Patenterteilung:
**16.06.2021   Patentblatt 2021/24**

(21) Anmeldenummer: **18782303.4**

(22) Anmeldetag: **17.09.2018**

(51) Internationale Patentklassifikation (IPC):
*H04W 24/00* (2009.01)   *G01S 13/76* (2006.01)
*G01S 13/46* (2006.01)

(52) Gemeinsame Patentklassifikation (CPC):
**H04W 24/00; G01S 13/765; G01S 13/767;**
G01S 2013/462

(86) Internationale Anmeldenummer:
**PCT/EP2018/000435**

(87) Internationale Veröffentlichungsnummer:
**WO 2019/052686 (21.03.2019 Gazette 2019/12)**

(54) **VERFAHREN FÜR FUNKMESSANWENDUNGEN**

METHOD FOR RADIO MEASURING APPLICATIONS

PROCÉDÉ POUR DES APPLICATIONS DE MESURE RADIO

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.09.2017   DE 102017008647**
**15.09.2017   US 201762559116 P**

(43) Veröffentlichungstag der Anmeldung:
**29.04.2020   Patentblatt 2020/18**

(73) Patentinhaber: **Metirionic GmbH**
**01069 Dresden (DE)**

(72) Erfinder: **EGGERT, Dietmar**
**01219 Dresden (DE)**

(74) Vertreter: **Viering, Jentschura & Partner mbB**
**Patent- und Rechtsanwälte**
**Am Brauhaus 8**
**01099 Dresden (DE)**

(56) Entgegenhaltungen:
EP-A1- 2 196 823        EP-A1- 2 312 334
EP-A2- 3 315 995        WO-A1-2005/119379
WO-A1-2012/155990       WO-A1-2017/037132
WO-A2-02/01247          US-A1- 2009 149 198
US-A1- 2010 074 133     US-A1- 2016 363 659
US-A1- 2017 176 583     US-A1- 2017 180 011
US-B2- 8 446 254

# EP 3 643 104 B2

**Beschreibung**

Die Erfindung betrifft ein Verfahren für Funkmessanwendungen mit wenigstens drei Funkknoten zur Ermittlung einer Transferfunktion zwischen den Funkknoten.

Es gibt eine Vielzahl von Verfahren zur Abstandsermittlung auf Basis der Messung von Phasen und Phasen-Differenzen von Referenz-Signalen im Frequenzbereich. Das Grundprinzip ist seit mehr als 50 Jahren bekannt, z.B. aus der US 3 243 812. Das Verfahren wird seit Jahrzehnten in Verschiedenen Applikation angewandt. Neben einer Vielzahl von Publikation gibt es auch eine ganze Reihe von Patenten.

Aus der DE 10 2009 060 505 B4 ist ein Verfahren zur Kommunikation zwischen zwei Funkknoten bekannt, wobei die Funkknoten wechselseitig Signale senden und empfangen und die Trägerfrequenzen der Signale für jede Wiederholung geändert werden. Die von dem zweiten Funkknoten extrahierten Phasenwerte werden im Anschluss an den ersten Funkknoten rückübertragen und dann mit den empfangenen Signalen des ersten Funkknoten ausgewertet, um einen Abstand zwischen den beiden Funkknoten zu bestimmen.

Aus der DE 10 2009 060 593 A1 ist ein weiteres Verfahren zur Entfernungsmessung zwischen zwei Funkknoten bekannt, wobei die Funkknoten unmodulierte Trägersignale austauschen, jeder Funkknoten zwei Phasenwerte für zwei Frequenzen ermittelt und aus den insgesamt vier Phasenwerten die Entfernung zwischen den Funkknoten bestimmt wird.

Alternative Verfahren zur Entfernungsmessung zwischen zwei Funkknoten sind aus der DE 10 2009 592 B4, der WO 02/01247 A2, der US 2009/0149198 A1 und der DE 10 2009 060 591 A1 bekannt.

Aus der WO 2005/119379 A1 ist ein Verfahren zur Korrektur von Jitter bekannt, wobei ein erster Funkknoten auf ein ausgesandtes Initialsignal ein Antwortsignal von einem zweiten Funkknoten erhält und das Antwortsignal sowohl den von dem zweiten Funkknoten ermittelten Empfangszeitpunkt des Initialsignals sowie den Sendezeitpunkt des Antwortsignals selbst enthält.

Vor diesem Hintergrund besteht die Aufgabe der Erfindung darin, ein Verfahren anzugeben, das den Stand der Technik weiterbildet.

Die Aufgabe wird durch ein Verfahren für Funkmessanwendungen mit den Merkmalen des Patentanspruchs 1 gelöst. Vorteilhafte Ausgestaltungen der Erfindung sind Gegenstand der Unteransprüche.

Gemäß dem Gegenstand der Erfindung wird ein Verfahren für Funkmessanwendungen mit wenigstens drei Funkknoten bereitgestellt, wobei während eines Messzyklus mindestens zwei Funkknoten eine Zelle bilden, mindestens ein weiterer Funkknoten ein Extrafunkknoten ist und der Messzyklus wenigstens zwei Schritte umfasst.

Während des Messzyklus arbeiten mindestens zwei Funkknoten der Zelle mindestens einmal in einem der wenigstens zwei Schritte in einem Sendemodus und mindestens einmal in einem der wenigstens zwei Schritte in einem Empfangsmodus. Der mindestens eine Extrafunkknoten arbeitet während des Messzyklus ausschließlich in einem Empfangsmodus oder ausschließlich in einem Sendemodus.

Jeder der Funkknoten weist jeweils einen eigenen Zeitgeber und eine weitere Datenschnittstelle für den Datentransfer auf.

Zwischen den Zeitgebern besteht jeweils ein Zeitversatz.

Während jedes Messzyklus sind zumindest alle Sendesignale der Funkknoten der Zelle zueinander kohärent.

Zum Eröffnen des Messzyklus wird in dem ersten Schritt von einem der Funkknoten in dem Sendemodus das Initialsignal mit einer ersten Trägerfrequenz ausgesandt und zumindest von mindestens einem Funkknoten der Zelle in dem Empfangsmodus empfangen.

Während des Messzyklus wechselt in mindestens einem weiteren Schritt mindestens ein Funkknoten der Zelle von dem Empfangsmodus in den Sendemodus und sendet das Antwortsignal mit einer weiteren Trägerfrequenz aus, wobei das Antwortsignal von mindestens einem Funkknoten der Zelle in dem Empfangsmodus empfangen wird.

Während des Messzyklus empfängt mindestens einer der Extrafunkknoten mindestens ein Signal oder sendet mindestens ein Signal.

Wenigstens zwei Messzyklen werden auf verschieden Trägerfrequenzen ausgeführt.

Das Verfahren arbeitet in einem ersten Modus, wobei in dem ersten Modus jedes Antwortsignal zumindest aus einem Teil des empfangenen Initialsignals oder aus einem Teil eines empfangenen Antwortsignals gebildet und mindestens eine Transferfunktion und/oder mindestens einer der Zeitversätze anhand der empfangenen Antwortsignale ermittelt wird

In einem nicht unter den Anspruch 1 fallenden zweiten Modus wird jedes Antwortsignal unabhängig von jedem empfangenen Signal gebildet, mindestens zwei empfangene Initialsignale werden mittels der weiteren Datenschnittstelle übermittelt und mindestens eine Transferfunktion und/oder mindestens einer der Zeitversätze wird anhand der empfangenen Antwortsignale und der mindestens zwei einen empfangenen und übermittelten Initialsignale ermittelt.

Es versteht sich, dass jeder Funkknoten eine Empfangseinheit, eine Sendeeinheit, einen Signalprozessor, die weitere Datenschnittstelle und wenigstens eine Antenne umfasst. Des Weiteren versteht es sich, dass in einem Schritt jeweils nur ein Funkknoten sendet.

Umfasst ein Funkknoten mehrere Antennen, so wird das Initialsignal und/oder das Antwortsignal von einer der Antennen gesendet oder das Initialsignal und/oder das Antwortsignal wird von mehreren Antennen abgestrahlt. Beispielsweise strahlen die Antennen während eines Sendezeitraums sequentiell nacheinander ab. Der Sendezeitraum ist hierfür z.B. in mehrere Zeitfenster unterteilt, wobei jeweils eine der Antennen während eines Zeitfensters sendet. Es versteht sich, dass auch der Empfang der Signale entsprechend organisiert sein kann.

Die Zelle umfasst erfindungsgemäß mindestens zwei Funkknoten und kann um weitere Funkknoten erweitert werden. Außerdem steht mindestens ein weiterer Funkknoten als Extrafunkknoten zur Verfügung. Die Anordnung kann auch durch weitere Extrafunkknoten erweitert werden. Der mindestens eine Extrafunkknoten bzw. alle Extrafunkknoten nicht Teil der Zelle sind.

Die Datenschnittstelle ist in alternativen Ausführungsformen drahtgebunden oder drahtlos ausgebildet und ermöglicht den Austausch von Daten, z.B. von ermittelten Signalvektoren, sowie die grobe Synchronisation der Funcknoten. Es sei angemerkt, dass die Ausbildung der Datenschnittstelle vorliegend nicht Gegenstand des Verfahrens ist.

Mittels des Verfahrens lassen sich Transferfunktionen bestimmen. Voraussetzung ist, dass eine Kohärenz der Signale zumindest während des Messzyklus gegeben ist.

Die Transferfunktion bildet die Übertragungseigenschaften zwischen zwei Funkknoten im Frequenzbereich ab, also die Übertragung eines Signals über ein Ausbreitungsmedium, und stellt im Bereich der drahtlosen Datenübertragung eine übliche Bezeichnung dar. Vielfach wird die Transferfunktion auch als Übertragungsfunktion bezeichnet.

Es versteht sich, dass sich mittels einer Fourier-Transformation die aufgenommen Werte aus dem Frequenzbereich in den Zeitbereich transformieren lassen. Im Zeitbereich ist für das Übertragungsverhalten eines Ausbreitungsmediums auch der Begriff der Kanalimpulsantwort üblich.

Das Verfahren umfasst einen ersten und einen nicht in Anspruch 1 beanspruchten zweiten Modus, wobei jeder Modus für sich geschlossen ist. Maßgeblich für Modus 1 ist, dass innerhalb des Signalaustauschs zusätzliche Informationen innerhalb des Messsignals übermittelt werden, während Modus 2 ausschließlich die Datenschnittstelle für die Übertragung dieser Informationen nutzt. Ein System arbeitet jeweils innerhalb eines Zeitraums in einem der Modi. Ein Übergang zwischen den Modi ist möglich.

Mittels des Verfahrens ist es möglich, eine Übertragung von dem einem Funkknoten zu dem weiteren Funkknoten und zurück (auch als 2WR-Umlauftransferfunktion bezeichnet) zu bestimmen.

Aus der Messung der Transferfunktion im Frequenzbereich lassen sich Abstandsdifferenzen und/oder Abstände zwischen den beteiligten Funkknoten bestimmen.

Dabei kommt insbesondere dem Phasengang zwischen den Signalen eine besondere Bedeutung zu. Wird das Ausbreitungsverhalten innerhalb eines Mediums von dem direkten Pfad dominiert, dann lässt sich aus dem Phasengang über eine Ableitung die Gruppenlaufzeit $t_g$ der elektromagnetischen Welle ermitteln.

$$t_g = \frac{d\varphi}{d\omega}$$

Über die Ausbreitungsgeschwindigkeit c der elektromagnetischen Welle entsteht eine direkte Beziehung zu dem Abstand d zwischen den Funkknoten entsprechend $d = c \cdot t_g$.

Kennzeichnend für alle Messverfahren ist das wechselseitige Senden und Empfangen von Referenzsignals, also des Initialsignals bzw. des mindestens einen Antwortsignals, wobei jeder Funkknoten die Lage des Empfangssignals jeweils in der komplexen Ebene bzgl. der eigenen internen Zeitreferenz bewertet wird.

Ein Messzyklus aus dem ersten Schritt und mindestens einem weiteren Schritt stellt eine Kernoperation des Verfahrens dar, die auch als Atomic Operation oder als Ping-Pong bezeichnet wird.

In dem ersten Schritt wird das Initialsignal von einem Funkknoten der Zelle oder von einem Extrafunkknoten gesendet.

Wird das Initialsignal in dem ersten Schritt von einem Extrafunkknoten gesendet, so umfasst jeder Messzyklus mindestens zwei weitere Schritte, wobei in den weiteren Schritten jeweils ein Funkknoten der ersten Einheit ein Antwortsignal sendet.

Die Phasenkohärenz der Signale muss im Minimum über einen Messzyklus also eine Kernoperation zumindest innerhalb der Zelle erhalten sein.

Die Erhaltung der Phasenkohärenz der Signale über einen abgegrenzten Zeitraum und zwischen den Funcknoten ist eine wichtige Eigenschaft des Verfahrens und eine Voraussetzung für eine Rekonstruktion des Signalverlaufs.

Die Kohärenz-Forderung ist je nach Ausführung auf mehrere Messzyklen auszuweiten.

Der Übertragungskanal ist in vielen Fällen durch mehrere Wege gekennzeichnet, wobei neben der direkten Verbindung zwischen zwei Funkknoten auch weitere Pfade durch Reflexion an Gegenständen und/oder durch Brechung und/oder durch Beugung entstehen können.

Um mehrere Wege in den empfangenen Signalen aufzulösen wird der Messzyklus, also das wechselseitige Senden und Empfangen von Signalen, in Frequenzschritten über eine Bandbreite (vorbestimmten Frequenzbereich) mehrfach wiederholt. Hierdurch lassen sich die Transferfunktionen jeweils basierend auf eine Menge von Stützstellen im Frequenzbereich ermitteln.

Die Bandbreite des vorbestimmten Frequenzbereichs ist bestimmend für die Fähigkeit des Verfahrens, Signal-Pfade mit unterschiedlichen Längen aufzulösen. Da es sich um eine frequenz-diskrete Darstellung handelt,. bestimmt die Frequenzschrittweite den Bereich über den sich ein Abstand eindeutig ermitteln lässt und begrenzt gleichzeitig die Größe der eindeutig bestimmbaren Zeitversätze.

Neben Abständen oder Abstandsdifferenzen ist auch eine Extraktion von weiteren Parametern, z.B. einem Einfallswinkel zwischen Funkknoten (zwei oder mehrere) für eine relative Positionsbestimmung, möglich. Dazu sind die Empfangssignale mehrerer Antennen auszuwerten bzw. die Sendesignale auf mehrere Antennen determiniert zu verteilen. Dies kann parallel/gleichzeitig durch Nutzung mehrerer Sende- und Empfangseinheiten erfolgen. Alternative kann auch die Antennenzuordnung zeitlich nacheinander auf verschiedenen Zeitfenstern innerhalb der Schrittfolge und durch Umschalten der Antennen zwischen den Zeitfenstern erfolgen. Beim Umschalten sind entsprechende Einschwingvorgänge zu beachten.

Vorzugsweise entspricht der vorbestimmte Frequenzbereich beispielsweise dem zur Verfügung stehenden Frequenzbereich, richtet sich also nach den von den verwendeten Funkknoten zur Verfügung gestellten Bandbreiten. Alternativ wird der technisch mögliche Frequenzbereich aufgrund gesetzlicher Vorgaben und/oder aufgrund einer konkreten Anwendung eingeschränkt, so dass der vorbestimmte Frequenzbereich nur einen Teilbereich des zur Verfügung stehenden Frequenzbereichs umfasst.

Jeder Funkknoten folgt einem festen zeitlichen Ablauf, der fest an den Zeitgeber und die entsprechende Zyklussteuerung gebunden und daher deterministisch ist. Damit haben alle Funktionsblöcke über die erforderlichen Zeiträume einen festen Zeit- und Phasenbezug und erfüllen die jeweiligen Forderungen nach Phasenkohärenz. Da das Zeitverhalten der Funkknoten unter den Knoten a-priori (mit Ausnahme von Initialphasenlage, Zeit- und Frequenzoffset) bekannt ist, entsteht eine Kohärenzbeziehung zwischen den Funkknoten.

Für den Ablauf des Verfahrens ist es jedoch wichtig, dass die entsprechenden Sende- und Empfangszeiträume (ggfs. auch Sende- und Empfangszeitfenster) sich gegenüberstehen und entsprechende Einschwingvorgänge abgeschlossen, d.h. ein stationärer Zustand hergestellt wird.

Die tolerierbare Schwankung des Zeitversatzes, die durch eine Grob-Synchronisation abgesichert wird, orientiert sich an der Größe des Messbereichs und sollte z.B. bei einem Messbereich von 300m geringer als $1\mu s$ sein um erhöhte Aufwände in Zeit- und Frequenzoffsetkorrektur zu vermeiden. Die erreichbare Messgenauigkeit im 2.4GHz Bereich liegt bei unter einem 1m.

Bzgl. dieser Eigenschaft unterscheidet sich dieses Verfahren maßgeblich von etablierten UWB TDOA (Time Difference of Arrival) Verfahren. Da hier die Messgenauigkeit durch die Synchronisation bestimmt wird, muss die Synchronisationsgüte bei vergleichbarer Genauigkeit besser als 3ns sein.

Wie angemerkt, verfügt jeder Funkknoten über eine eigene Zeitreferenz. Vorzugsweise ist die Zeitreferenz als Quarzoszillator (XTAL/XOSC) ausgebildet. Es versteht sich, dass der grobe Zeitabgleich nicht die Ermittlung des tatsächlichen Zeitoffsets bei einer Kernoperation ersetzt, sondern eine Voraussetzung ist.

Ein Vorteil ist, dass sich die Flexibilität des Verfahrens und die Zuverlässigkeit erhöht. Ein anderer Vorteil ist, dass sich das Verfahren schneller und kostengünstiger durchführen lässt. Insbesondere lässt sich das Verfahren vorteilhaft bei Ermittlung der Position von Funkknoten im Bereich der Sensornetzwerke einsetzen. Des Weiteren erlaubt das Verfahren hochauflösende Abstandsmessungen in großen Reichweitenbereichen, d.h. in einem Bereich von 0.5 m bis 10 Km, durchzuführen. Insbesondere mittels der Verwendung von Schmalbandarchitekturen, d.h. Kanalfilterbandbreite kleiner 1MHz, werden ein hoher Dynamikbereich und eine hohe Störfestigkeit erreicht.

Die Ermittlung des Zeitoffsets bzw. des Zeitversatzes zweier an der Kommunikation beteiligter Funkknoten ist für eine Weiterverarbeitung der Messergebnisse von Bedeutung.

Als Datenschnittstelle wird jede weitere Art eines Datenaustauschs bezeichnet, also beispielsweise ein Kommunikationsprotokoll für einen drahtlosen Austausch, z.B. Bluetooth, Zigbee oder IEEE 802.11, welches einen Austausch von Datenframes zur groben Synchronisation ermöglicht. Alternativ kann die Datenschnittstelle als eine Datenleitung bzw. Anschluss für eine Datenleitung ausgebildet sein.

Wird gemäß dem ersten Modus jedes Antwortsignal zumindest aus einem Teil des empfangenen Initialsignals gebildet, so werden entsprechend Informationen über das empfangene Initialsignal bzw. ein empfangenes Antwortsignal zurück bzw. weiter übermittelt. Jedes gemäß dem ersten Modus gebildete Antwortsignal enthält somit Informationen über mindestens zwei Wege.

Wird gemäß dem zweiten Modus jedes Antwortsignal unabhängig von dem Initialsignal gebildet, so wird mindestens ein ermittelter Empfangssignalvektor mittels der Datenschnittstellen des entsprechenden Funkknotens an einen weiteren Funkknoten oder eine Recheneinheit übermittelt.

Wird anhand von mindestens einem Initialsignal und mindestens einem Antwortsignal der Zeitversatz bestimmt, so ist es möglich, die 1WR-Transferfunktion zu bestimmen. Die ist sowohl in dem ersten Modus als auch in dem zweiten Modus möglich.

Ein Vorteil des ersten Modus des erfindungsgemäßen Verfahrens ist somit, dass eine zusätzliche Datenübermittlung von Messergebnissen entfällt. Hierdurch kann sowohl der technische als auch der zeitliche Aufwand reduziert werden.

Gemäß einer ersten Ausführungsform werden in der Zelle mindestens drei Funkknoten bereitgestellt, wobei jeder der mindestens drei Funkknoten in mindestens einem Schritt sendet und in allen weiteren Schritten empfängt, wobei in jedem Schritt nur ein einziger der Funkknoten sendet.

In einer anderen Ausführungsform sind alle Funkknoten der Zelle dazu ausgelegt, in einem Empfangsmodus und in einem Sendemodus zu arbeiten und während mindestens eines Messzyklus mindestens einer der Funkknoten der Zelle weder im Sendemodus und noch im Empfangsmodus arbeitet.

Hierdurch wird es ermöglicht, weitere Funkknoten als Backup vorzusehen oder auch während weiterer Messzyklen auf weitere oder andere Funkknoten zurückzugreifen. Beispielsweise sind in aufeinanderfolgenden Messzyklen immer zwei unterschiedliche Funkknoten der Zelle aktiv und bilden ein Funkknotenpaar, wobei das Funkknotenpaar jeweils ein Initialsignal und ein Antwortsignal austauscht.

In einer Weiterbildung werden mehrere Extrafunkknoten bereitgestellt.

In einer anderen Weiterbildung wird mittels mehrerer Messzyklen die Position eines der Funkknoten innerhalb der Zelle ermittelt.

In einer Ausführungsform wird mittels mehrerer Messzyklen die Position eines der Extrafunkknoten ermittelt. Ein ausschließlich im Empfangsmodus arbeitender Extrafunkknoten ermittelt anhand der empfangenen Signale Abstandsdifferenzen. Über mehrere Messzyklen ist es außerdem möglich, aus den mehreren Abstandsdifferenzen auch die absolute Position des Extrafuncknotens zu bestimmen.

In einer Weiterbildung wird ein Messdurchgang aus mehreren Wiederholungen des Messzyklus gebildet und mindestens ein erster Funkknoten ist in mindestens einem ersten Messdurchgang Teil der Zelle und arbeitet in mindestens einem weiteren Messdurchgang als Extrafunkknoten und/oder arbeitet mindestens ein weiterer Funkknoten in mindestens einem ersten Messdurchgang als Extrafunkknoten und ist in mindestens einem weiteren Messdurchgang Teil der Zelle.

Das Wechseln der Funktionalität der Funkknoten von Messdurchgang zu Messdurchgang erhöht die Flexibilität und/oder Zuverlässigkeit des Verfahrens. Es ermöglicht auch Kalibrationsvorgänge.

Gemäß einer anderen Ausführungsform sind die Funkknoten der Zelle an vorgegebenen Positionen angeordnet.

Die Funkknoten der Zelle dienen als Ankerknoten, während der mindestens einen Extrafunkknoten mobil bzw. beweglich angeordnet ist und als Tag dient. Anhand der von dem Extrafunkknoten empfangenen oder ausgesandten Signale werden beispielsweise Abstandsdifferenzen oder akkumulierte Wege ermittelt. Umfasst die Zelle mindestens drei Funkknoten mit bekannter Position ist es möglich, eine dreidimensionale Position des mindestens einen Extrafuncknotens zu bestimmen.

Eine Betriebsart mit mindestens einem ausschließlich im Sendemodus arbeitenden Extraknoten wird auch als Blink-Modus bezeichnet. Eine Betriebsart mit mindestens einem ausschließlich im Empfangsmodus arbeitendem Extraknoten wird auch als GPS-Modus bezeichnet. Es versteht sich, dass für beide Betriebsarten auch mehrere entsprechende Extraknoten bereitgestellt bzw. eingesetzt werden können.

Durch Bereitstellung von weiteren Extrafunkknoten, die ebenfalls nur in dem Empfangsmodus arbeiten, kann die Anzahl der Abstände, die innerhalb eines Messzyklus oder eines Messdurchgangs gemessen werden können, erweitert werden. Es entsteht pro Extrafunkknoten ein weiterer Distanz-Wert. Ein großer Vorteil dieser Ausführungsvariante ist, dass die Anzahl der Schritte innerhalb eines Messzyklus nicht erweitert werden muss. Damit kann durch Hinzufügen von Extrafunkknoten die Messgeschwindigkeit signifikant erhöht werden.

In einer Weiterbildung arbeiten mindestens ein erster Extrafunkknoten ausschließlich im Sendemodus und mindestens ein zweiter Extrafunkknoten ausschließlich im Empfangsmodus, wobei der zweite Funkknoten an einer vorgegebenen Position angeordnet ist.

Diese Ausführungsform stellt eine Erweiterung des Blink-Modus (mindestens ein sendender Extraknoten als mobiler Tag, mindestens zwei Knoten in der Zelle als Anker-Knoten) durch mindestens einen zweiten, ausschließlich im Empfangsmodus arbeitenden Extrafunkknoten. Aufgrund der bekannten Position des zweiten Extrafunkknotens dient dieser als passiver Ankerknoten.

In einer weiteren Ausführungsform sind alle Funkknoten an einer vorgegebenen Position angeordnet.

Diese Ausführungsform ermöglicht es, alle Zeitoffsets, also die Zeitoffsets zwischen allen beteiligten Funkknoten zu ermitteln. Dies kann beispielsweise zur Kalibration genutzt werden.

Gemäß einer alternativen Ausführungsform sind der mindestens eine Extrafunkknoten und mindestens ein erster Funkknoten der Zelle an einer vorgegebenen Position angeordnet und mindestens ein Extrafunkknoten arbeitet ausschließlich in einem Empfangsmodus.

Diese Betriebsart wird auch als Hybrid-Modus bezeichnet und ermöglicht insbesondere das Bestimmen von Abständen zwischen Funkknoten. Der mindestens eine Extrafunkknoten sowie zumindest der erste Funkknoten der Zelle dienen als Ankerknoten, während mindestens ein zweiter Funkknoten der Zelle mobil ist und als Tag-Knoten dient. Vorteilhafter Weise werden mehrere Extraknoten bereitgestellt. Ermittelt werden alle Wegdifferenzen, akkumulierten Wege und/oder Abstände zu den Extraknoten, woraus auf eine relative oder absolute Position des mobilen Funkknotens der Zelle geschlossen werden kann.

Gemäß einer weiteren Ausführungsform wird ein Messdurchgang aus mehreren Wiederholungen des Messzyklus gebildet, wobei das Initialsignal und jedes Antwortsignal jeweils mindestens während eines Messdurchgangs oder mindestens während mehrere Messdurchgänge kohärent sind.

In einer weiteren Ausführungsform wird in dem ersten Modus aus dem empfangenen Initialsignal oder aus einem der empfangenen Antwortsignale ein komplexer Signalvektor ermittelt und das zu sendende Antwortsignal aus dem komplexen Signalvektor oder aus dem Reziproken des komplexen Signalvektors gebildet.

Gemäß einer Alternative wird in dem ersten Modus aus dem empfangenen Initialsignal oder aus einem der empfangenen Antwortsignale ein komplexer Signalvektor ermittelt und das zu sendende Antwortsignal unter Verwendung des konjugiert komplexen Signalvektors gebildet.

Gemäß einer weiteren Alternative wird in dem ersten Modus aus dem empfangenen Initialsignal oder aus einem der empfangenen Antwortsignale eine Phase ermittelt und unter Verwendung der Phase oder der invertierten Phase das zu sendende Antwortsignal gebildet wird.

In einer anderen Ausführungsform wird ein Messdurchgang von mehreren Wiederholungen des Messzyklus gebildet und die erste Trägerfrequenz des ersten Sendesignals nimmt bei jeder Wiederholung während des Messdurchgangs jeweils einen vorbestimmten Wert innerhalb des Frequenzbereichs an.

Beispielsweise wird ein Frequenz-Sweep durchgeführt, wobei die erste Trägerfrequenz bei jeder Wiederholung während des Messzyklus jeweils um einen konstanten Wert innerhalb des vorgegebenen Frequenzbereichs erhöht oder verringert wird. Ein Sweep ist mit geringem Implementierungsaufwand umsetzbar. In der Regel ist es einfacher die Phasenbeziehungen über eine Vielzahl kleinerer Frequenzschritte aufrechtzuerhalten. Auf Grund von gesetzlichen Bestimmungen ist diese Ausführung jedoch für viele Anwendungen in der zulässigen Sendeleistung beschränkt.

Eine unregelmäßigere Änderung der Frequenz wird auch als Frequenz-Hopping bezeichnet. Die unterschiedlichen Frequenzen bzw. Werte für die Trägerfrequenz für jede einzelne Wiederholung sind beispielsweise in einem Lookup-Table hinterlegt oder richten sich nach einer vorgegebenen mathematischen Funktion. Beispielsweise kann das Frequenz-Hopping auf Basis von pseudorauschartigen Folgen durchgeführt werden, wodurch eine hohe Robustheit gegen Störquellen erreicht wird. Gleichzeitig erlaubt diese Ausführung des Verfahrens die Nutzung größerer Sendeleistungen bei Einhaltung der verschiedensten gesetzlichen Bestimmungen und regulatorische Vorgaben. Somit ist es möglich die Nutzung des Verfahrens auf größere Reichweiten zu erweitern.

In einer weiteren Ausführungsform entspricht jede weitere Trägerfrequenz der ersten Trägerfrequenz oder jede weitere Trägerfrequenz unterscheidet sich von der ersten Trägerfrequenz.

Es versteht sich, dass der zeitliche Verlauf der Trägerfrequenzen bzw. die Frequenzänderungen den beteiligten Funkknoten vorab bekannt sind. Die zweite Trägerfrequenz wird beispielsweise immer der ersten Trägerfrequenz entsprechend geändert. Die Änderung der zweiten Trägerfrequenz erfolgt alternativ unabhängig von der Änderung der ersten Trägerfrequenz oder gar nicht. Die Änderung, d.h. der bei einer Wiederholung vorgenommene Frequenzschritt, ist bei jeder Wiederholung gleich oder ändert sich bei jeder Wiederholung, beispielsweise gemäß einer vorgegebenen allen Funkknoten bekannten Liste oder mathematischen Funktion, die auch das zeitliche Verhalten einschließt und damit die erforderliche Phasenkohärenz erhält.

In einer weiteren Ausführungsform wird für mindestens eine ermittelte Transferfunktion eine Mehrwege-Analyse durchgeführt.

In einer anderen Ausführungsform wird auf das empfangene Initialsignal und/oder das mindestens eine empfangene Antwortsignal ein Filter angewandt.

Gemäß einer weiteren Ausführungsform werden bei jeder Wiederholung des Messzyklus zusätzlich zu der Trägerfrequenz des Antwortsignals eine Amplitude und/oder eine Phase des Antwortsignals verändert.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. Abstände sowie laterale und vertikale Erstreckung sind nicht maßstäblich und weisen, sofern nicht anders angegeben, auch keine ableitbaren geometrischen Relationen zueinander auf. Darin zeigen,

Figur 1     Anordnung von drei Funkknoten für Funkmessanwendungen gemäß einer ersten Ausführungsform,

Figur 2     Darstellung zweier eine Zelle bildender Funkknoten in Funktionseinheiten und ihren wesentlichen Eigenschaften.

Figur 3     Darstellung der Funktionseinheit der drei Funkknoten gemäß der ersten Ausführungsform,

Figur 4     Zeitliches Ablaufschema gemäß der ersten erfindungsgemäßen Ausführungsform,

Figur 5     Darstellung von in den Zeitbereich transformierten Signalvektoren,

Figur 6     Erweiterung des ersten Ausführungsbeispiels,

Figur 7     Anordnung von drei Funkknoten für Funkmessanwendungen gemäß einer zweiten Ausführungsform,

Figur 8     Zeitliches Ablaufschema gemäß der zweiten Ausführungsform,

Figur 9     Darstellung von in den Zeitbereich transformierten Signalvektoren,

Figur 10     Erweiterung des zweiten Ausführungsform,

Figur 11     alternative Erweiterung des zweiten Ausführungsform,

Figur 12     weitere alternative Ausführungsform.

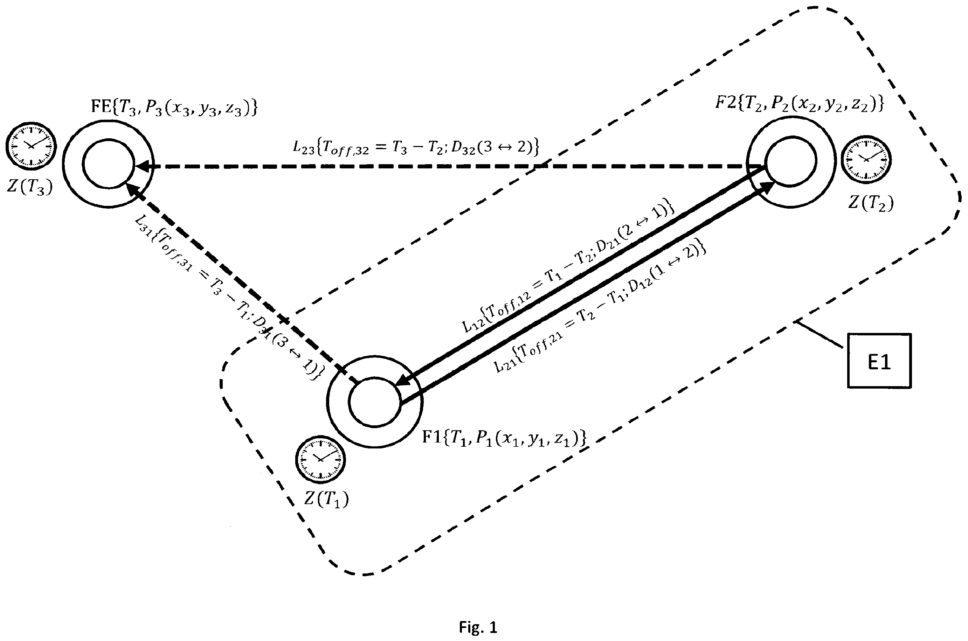

Die Figur 1 zeigt eine Anordnung von drei Funkknoten F1, F2 und FE zur Durchführung einer ersten Ausführungsform eines erfindungsgemäßen Verfahrens für Funkmessanwendungen, wobei die Anordnung dazu ausgelegt ist, einen ersten Modus des erfindungsgemäßen Verfahrens auszuführen.

Jeder der Funkknoten besitzt seinen eigenen Zeitgeber Z(T1) bzw. Z(T2) bzw. Z(T3), wobei die Zeitgeber jeweils die Zeitbasis T1, T2 bzw. T3 des jeweiligen Funkknotens F1, F2 bzw. FE vorgeben und die Zeitgeber Z(T1), Z(T2) und Z(T3) jeweils voneinander unabhängig sind. Die Zeitgeber sind jeweils als Quarzoszillator ausgebildet. Es wird vorausgesetzt, dass die verschiedenen Zeitgeber Z(T1) bzw. Z(T2) bzw. Z(T3) in gleichen Einheiten fortschreiten (z.B. bestimmt durch die Frequenz eines internen Taktgebers), sodass die Unterschiede in den Zeitbases T1, T2 und T3 jeweils auf einen Zeitversatz reduzierbar sind. (Ein etwaiger Frequenzoffset zwischen den Zeitgebern wird von weiteren Betrachtungen ausgeschlossen. Im Falle eines Frequenzoffset werden entsprechende Korrektur-Maßnahmen vorgenommen, die den Frequenzoffset korrigieren.)

Der Zeitversatz zwischen den Funkknoten ist der Versatz zwischen den jeweiligen Zeitgebern und ist richtungsabhängig, wobei in den weiteren Betrachtungen immer der sendende Funkknoten als Bezugsknoten verwendet werden soll: Ist der ersten Funkknoten F1 der sendende Knoten und der zweite Funkknoten F2 der empfangende Knoten, so sei der entsprechende Zeitversatz $T_{off,21}$=T2-T1. Der Zeitversatz in der umgekehrten Richtung ist $T_{off,12}$=T1-T2, wobei $T_{off,21}$=-$T_{off,12}$ gilt. Bei Einbeziehung des Extraknotens FE ergibt sich ein weiterer Zeitversatz $T_{off,31}$=T3-T1, wobei auch hier gilt: $T_{off,31}$=-$T_{off,13}$. Gleichzeitig entsteht ein dritter Zeitversatz $T_{off,23}$= T2-T3, zwischen dem zweiten Knoten F2 und dem Extrafunkknoten FE. Der dritte Zeitversatz kann auch durch den akkumulierten Zeitversatz des Extrafunkknoten FE über den ersten Knoten F1 zum zweiten Funkknoten F2 mit $T_{off,23}$=$T_{off,21}$+$T_{off,13}$ bestimmt werden. Analog gilt: $T_{off,32}$= $T_{off,12}$+$T_{off,31}$.

Die Funkknoten F1, F2 und FE befinden sich an Positionen P1, P2 und P3, die z.B. durch ihre x-, y- und z-Koordinaten innerhalb eines kartesischen Koordinatensystems als $P1(x_1,y_1,z_1)$, $P2(x_2,y_2,z_2)$ und $P_3(x_3,y_3,z_3)$ festgelegt sind. Die Positionen der einzelnen Funkknoten sind je nach Ausführungsform zumindest teilweise oder auch für alle Funkknoten bekannt. Funkknoten, deren Positionen bekannt ist, werden in der Folge auch als Referenzfunkknoten bezeichnet. Funkknoten, deren Position nicht bekannt ist, werden in der Folge auch als Tag-Knoten bezeichnet.

Das Verfahren in verschiedenen Ausführungsformen erlaubt die Bestimmung von Transferfunktionen. Über eine Analyse der Transferfunktionen wird eine Bestimmung von Abständen möglich.

Im Zusammenhang mit Messverfahren für zwei Funkknoten kann eine Zwei-Wege- Transferfunktion (auch Umlauftransferfunktion oder 2WR) zur Ermittlung von Abständen genutzt werden.

Abstände zwischen den Funkknoten ergeben sich aus den Koordinaten, beispielhaft für den Abstand zwischen den Funkknoten F1 und F2 zu:

$$D_{12} = \sqrt{(x_1 - x_2)^2 + (y_1 - y_2)^2 + (z_1 - z_2)^2}$$

Es versteht sich, dass die betrachten Abstände basierend auf extrahierten Laufzeiten von Signalen berechnet werden. Etwaige Verzögerungen innerhalb der Sende- und Empfangseinheiten verlängern die Signallaufzeit und spiegeln sich in den extrahierten Abständen wieder. Diese müssen durch entsprechende Kalibrierungen korrigiert werden.

Im Zusammenspiel von mehreren Funkknoten ergibt sich zusätzlich die Möglichkeit Weg-Differenz-Transferfunktionen und Transferfunktionen bzgl. des akkumulierten Wegs zu ermitteln, die direkt die Differenz der Länge bzw. die Summe zweier Wege aus Sicht eines dritten Knoten beinhalten. So sei beispielweise $D^3_{12(-)}$ die Weglängendifferenz der Weglänge zwischen Extrafunkknoten FE zu dem ersten Funkknoten F1 gegenüber der Weglänge zwischen Extrafunkknoten FE zu dem zweiten Funkknoten F2: $D^3_{12(-)}$=$D_{31}$-$D_{32}$.

Der akkumulierte Weg von dem ersten Funkknoten F1 zu dem Extrafunkknoten FE über den zweiten Funkknoten F2 ist: $D^2_{31(+)}$=$D_{32}$+$D_{21}$. Bei mehr als 3 Funkknoten erweitern sich die Möglichkeiten entsprechend.

Die zwei Funkknoten F1 und F2 bilden eine Zelle E1, wobei sowohl der erste Funkknoten F1 als auch der zweite Funkknoten F2 während eines Messzyklus mindestens einmal in einem Sendemodus und mindestens einmal in einem Empfangsmodus, während der Extrafunkknoten gemäß dem dargestellten Ausführungsbeispiel während des Messzyklus ausschließlich in dem Empfangsmodus arbeitet. Dabei umfasst ein Messzyklus das Senden eines Initialsignals sowie das Senden wenigstens eines Antwortsignals.

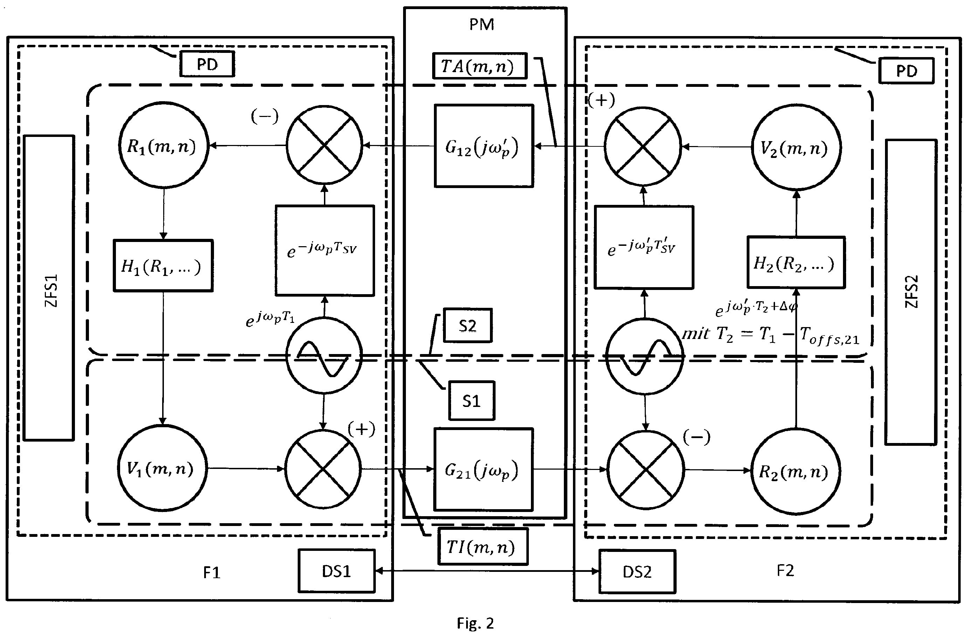

Die Struktur der Funkknoten der Zelle E1 bzw. die jeweils wesentlichen Signalverarbeitungsoperationen und entsprechenden Funktionsblöcke sind in Figur 2 dargestellt.

Die Funkknoten F1 und F2 besitzen jeweils eine Empfangseinheit RX, eine Sendeeinheit TX und eine Datenschnittstelle DS1, DS2 wobei jede Datenschnittstelle DS1 und DS2 ein Kommunikationsprotokoll für einen drahtlosen Datenaustausch unterstützt.

Wie Figur 2 zeigt, besitzen die Funkknoten F1 und F2 der Zelle E1 außerdem im dargestellten Ausführungsbeispiel einen Frequenzgenerator, eine Aufwärtsmischer, einen Abwärtsmischer, einen Funktionsblock H1 bzw. H2 und eine den Zeitgeber Z(T1) bzw. Z(T2) umfassende Zeit- und Frequenzsteuerung ZFS1 bzw. ZFS2.

Der Aufwärtsmischer konvertiert mit Hilfe des Frequenzgenerators einen komplexen Signalvektor V1 bzw. V2 aus der Basisband-Lage in die HF-Lage. Der Abwärtsmischer konvertiert ein Hochfrequenzsignal in einen Signalvektor R1 bzw. R2 in die Basisbandlage.

Der Funktionsblock H1 bzw. H2 erzeugt mittels einer ebenfalls als H1 bzw. H2 bezeichneten Funktion aus dem Empfangsvektoren R1 bzw. R2 und/oder Parametern, die über die jeweilige Datenschnittstelle DS1 bzw. DS2 bereitgestellt werden, einen komplexen Sendevektoren V1 bzw. V2 zur weiteren Erzeugung eines entsprechenden Sendesignals $T_1(m,n)$ und $T_2(m,n)$.

Die Sendesignale TI und TA werden über das Ausbreitungsmedium PM übertragen. Die Übertragungsfunktionen $G_{12}$ und $G_{21}$ für die jeweilige Ausbreitungsrichtung kennzeichnen den Einfluss des Ausbreitungsmediums PM auf die Sendesignale TI bzw. TA. Für einen typischen Funkkanal gilt $G_{12} = G_{21}$.

Die Zeit- und Frequenzsteuerung ZFS1 bzw. ZFS2 steuert alle Systemzustandswechsel in einem festen Zeitregime. Die Zeitsteuerung arbeitet auf Basis einer Zeiteinheit $T_{MU}$ und stellt sicher das alle relevanten Zustandswechsel (Sampling und Subsampling der Signalvektoren V1 und V2, Übergänge von dem Sendemodus in den Empfangsmodus sowie von dem Empfangsmodus in den Sendemodus und Frequenzwechsel fest mit der jeweiligen Zeitbasis verbunden sind und auf diese bezogen werden können.

Die Zeit- und Frequenzsteuerung ZFS1 bzw. ZFS2 ist auch dafür verantwortlich, dass die Kohärenz zwischen den Signalen über die geforderte Länge erhalten bleibt, d.h. Einschwingvorgänge berücksichtigt werden und sich alle Funktionsblöcke auch in den Übergangsbereichen in linearen Regelbereichen befinden (u.a. Frequenzgenerator, PLL). Die Funkknoten F1 und F2 werden durch die Zeit- und Frequenzsteuerung ZFS1 bzw. ZFS2 während des Messzyklus gesteuert. Der Messzyklus umfasst im dargestellten Ausführungsbeispiel zwei Schritte S1 und S2. Dies schließt auch die Übergangsbereiche (Schrittverzögerung) ein, die als Verzögerungsglieder der Größe $T_{SV}$ dargestellt sind. Die Zeit- und Frequenzsteuerung ZFS1 bzw. ZFS2 übernimmt auch die Steuerung der Frequenz $\omega_p$ über einen verfügbaren Frequenzbereich.

Dadurch erzeugt die Zeit- und Frequenzsteuerung ZFS1 bzw. ZFS2 jeweils eine phasenkohärente Domain PD, in der die Hochfrequenzsynthese, die Erzeugung der entsprechenden Sendevektoren und die Extraktion der Empfangsvektoren zueinander phasenseitig in einer festen Beziehung stehen.

Es versteht sich, dass das Vorbeschriebene nicht ausschließt, dass vor dem Auskoppeln in einem weiteren Mischer durch Multiplikation mit einem Hilfsträger, häufig als Local Oscillator bezeichnet, auf eine Zwischenfrequenz IF gebracht wird, bevor das Signal abschließend durch Umsetzung auf eigentlich Zielfrequenz $\omega_p$ umgesetzt wird. Gleiches gilt für den Empfangsprozess. Auch kann das empfangen Hochfrequenzsignal zunächst in eine Zwischenfrequenz-Ebene konvertiert werden und anschließend in das sogenannte Basisband umgesetzt zu werden.

Es versteht sich auch, dass das Verfahren einschließt, dass das Sendesignal in einer Direkt-Umsetzungs-Architektur ausgebildet ist, während die Empfangseinheit mit einer niedrigen Zwischenfrequenz arbeitet. In Konsequenz sind die entsprechenden Sendesignale um eine Zwischenfrequenz zueinander verschoben $f_p=f'_p\pm f'_{IF}$.

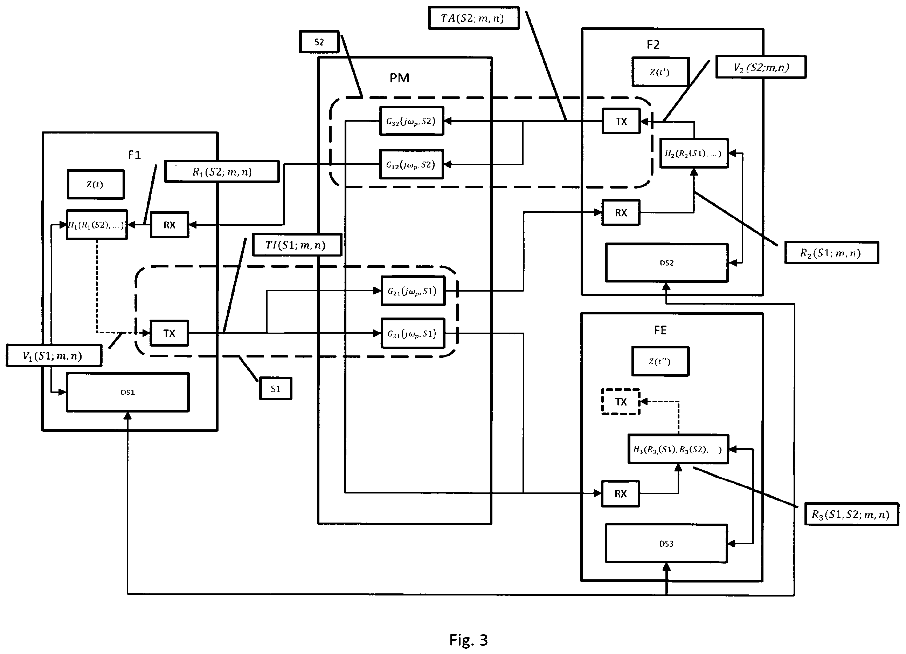

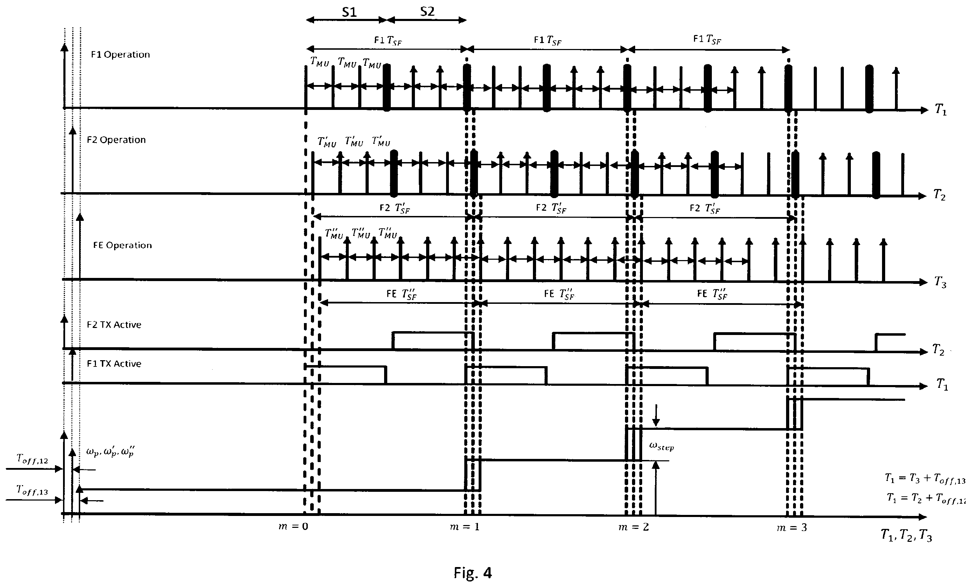

Die entsprechenden Abläufe des Verfahrens für Funkmessanwendungen gemäß der ersten alternativen Ausführungsform werden im Zusammenhang mit den Figuren 3 und Figur 4 erläutert.

Der Extrafunkknoten FE muss im Unterschied zu den Funkknoten F1 und F2 der Zelle E1, wie sie beispielsweise in der Figur 2 dargestellt sind, keine Sendeeinheit TX und keinen Aufwärtsmischer zur Erzeugung eines Sendesignals umfassen, da der Extrafunkknoten FE gemäß dem dargestellten Ausführungsbeispiel ausschließlich im Empfangsmodus arbeitet.

Die Sendeeinheit TX ist daher optional und in der Darstellung gestrichelt dargestellt. Ansonsten ist der Extrafunkknoten FE in dem dargestellten Ausführungsbeispiel genauso aufgebaut, wie die beiden Funkknoten F1 und F2 der Zelle E1.

Figur 3 und Figur 4 stellen die Operation der Funkknoten F1, F2 der Zelle E1 in Verbindung mit einen Extrafunkknoten FE, der nur im Empfangsmode arbeitet, dar. Während Figur 3 die Interaktion der Funkknoten mit dem Ausbreitungsmedium PM in den Mittelpunkt stellt, zeigt Figur 4 den zeitlichen Ablauf.

Im oberen Teil von Figur 4 wird die Operation der einzelnen Funkknoten F1, F2 und FE gezeigt. Die Pfeile stellen jeweils einen Sample und Samplezeitpunkt eines Empfangsvektors dar. Fette Balken kennzeichnen einen Übergang von dem Empfangsmodus auf den Sendemodus und umgekehrt. Die Striche ohne Pfeil verdeutlichen das Mitlaufen des jeweiligen Zeitgebers bzw. den Erhalt der jeweiligen Zeitbasis auch während sich ein Funkknoten in dem Sendemodus befindet. Die entsprechenden Sendezeiträume, in denen jeweils das zeitkontinuierliche Sendesignal erzeugt und abgestrahlt wird, sind in den mittleren Graphen dargestellt. In dem dargestellten Ausführungsbeispiel senden nur die Funkknoten F1 und F2 der Zelle E1.

Im unteren Teil von Figur 4 ist der Verlauf der Trägerfrequenz $\omega_p$ dargestellt. Alle Funkknoten F1, F2 und FE arbeiten in ihrer eigenen Zeitbasis T1, T2 bzw. T3, vorgegeben von dem jeweiligen Zeitgeber Z(T1), Z(T2) bzw. Z(T3), jeweils mit einer eigenen Zeiteinheit $T_{MU}$, $T'_{MU}$ bzw. $T'_{MU}$, auf deren Basis alle Aktionen erfolgen. Die Zeiteinheiten $T_{MU}$, $T'_{MU}$ bzw. $T'_{MU}$ bzw. das jeweils definierte Schrittmaß wird durchgehend über einen mehrere Wiederholungen des Messzyklus umfassenden Messdurchgang, bis zu mehreren Messdurchgängen aufrechterhalten.

Die Zeitachsen T2 des zweiten Funkknotens F2 bzw. T3 des Extrafunkknotens FE sind um den Zeitversatz $T_{offs,12}$ bzw. $T_{offs,13}$ gegenüber der Zeitachse T2 des Funkknoten F1 verschoben.

Innerhalb der Figur 4 kennzeichnet n den Index innerhalb eines Messzyklus, der eine Dauer von $T_{SF}=n_{max}\cdot T_{MU}$ besitzt. Der Index besitzt einen Wertebereich $n=0,1,...,(n_{max}-1)$, wobei sich $n_{max}$ aus der konkreten Auslegung des Messzyklus bestimmt und im dargestellten Beispiel $n_{max}=6$ gewählt wurde. Wie in Figur 4 dargestellt, bildet n im Zusammenhang mit der Messeinheitszeit $T_{MU}$, die Basis für ein zeitdiskretes System auf der Basis $t=n\cdot T_{MU}+m\cdot T_{SF}$. m bezeichnet hier den Index der Messzyklen eines Messdurchgangs, wobei in diesem Fall mit Beginn jedes Messzyklus die Frequenz der Frequenzgeneratoren, d.h. die jeweilige Trägerfrequenz, geändert wird. Der Index m hat einen Wertebereich $m=0,1,...,(m_{max}-1)$. $m_{max}$ wird durch die konkrete Ausführung bestimmt und ist u.a. von der Anzahl der Frequenzen abhängig, für die eine Übertragungsfunktion ermittelt werden soll. Zur Unterscheidung der entsprechenden Größen der einzelnen Funkknoten F1, F2 bzw. FE sind alle Größen durch unterschiedliche Anstriche (z.B. für die Frequenzen: $F1:f_p$, $F2:f'_p$, $FE:f''_p$) gekennzeichnet.

Jeder Funkknoten bildet für sich ein zeitdiskretes System mit

$$T1=n\cdot T_{MU}+m\cdot T_{SF} , \ T2=n\cdot T_{MU}+m\cdot T'_{SF} \ bzw. \ T3=n\cdot T''_{MU}+m\cdot T''_{SF}.$$

Wie in den Figuren 3 und 4 dargestellt, beginnt Funkknoten F1, während eines ersten Schritts S1 m=0, n=0,1,2 mittels der Sendeeinheit TX über ein Ausbreitungsmedium PM, z.B. Luft, ein Initialsignal TI zu senden. Die Wirkung des Ausbreitungsmediums auf das Sendesignal ist durch die entsprechenden Übertragungsfunktionen $G_{21}(j\omega_p;S1)$ bzw. $G_{31}(j\omega_p;S1)$ dargestellt.

Der zweite Funkknoten F2 (als Teil der ersten Zelle) und der Extrafunkknoten FE sind dazu ausgelegt während des ersten Schritts S1 das von dem ersten Funkknoten F1 ausgesandte Initialsignal TI nach einer Übertragung über das Ausbreitungsmedium PM als Empfangsvektor $R_2(S1;m,n)$ bzw. $R_3(S1;m,n)$ zu empfangen.

Alle Funkknoten sind dazu ausgelegt, zumindest einen Teil der empfangenen Information über die jeweilige Datenschnittstelle DS1, DS2 bzw. DS3 auszutauschen und zusätzliche Informationen für die Erzeugung des jeweiligen Sendevektors V1 bzw. V2 zu empfangen.

Gemäß dem ersten Modus des erfindungsgemäßen Verfahrens wird der Sendevektor V2(S2;m,n) von der Funktionseinheit H2 des zweiten Funkknotens F2 auf Basis des Empfangsvektors $R_2(S1;m,n)$ gebildet.

Während eines zweiten Schritts S2 sendet der zweite Funkknoten F2 mittels der Sendeeinheit TX ein auf dem Sendevektor V2(S2;m,n) basierendes Antwortsignal TA(S2;m,n). Der erste Funkknoten F1 der Zelle E1 und der Extrafunkknoten FE empfangen während des zweiten Schritts S2 mittels der Empfangseinheiten RX das von dem zweiten Funkknoten F2 ausgesandte Antwortsignal TA nach Übertragung über das Ausbreitungsmedium PM als Empfangsvektor $R_1(S2;m,n)$ und $R_3(S2;m,n)$. Die Übertragung über das Ausbreitungsmedium PM ist durch die Funktionen $G_{12}(j\omega_p;S1)$ und $G_{32}(j\omega_p;S1)$ dargestellt.

Wie in den Figuren 2, 3 und 4 veranschaulicht ist, erzeugt der jeweilige Frequenzgenerator der Funkknoten F1 und F2 der Zelle E1 sowie des Extrafunkknoten FE zunächst ein Signal der Frequenz $f_p$, $f'_p$, $f''_p$ mit $\omega_p=2\pi\cdot f_p$ ($\omega'_p$, $\omega''_p$ analog) mit (p=1), wobei das Signal des Frequenzgenerators der Funknoten F2 und FE um die Zeitversätze $T_{offs,21}$ und $T_{offs,31}$ verzögert sind. Weiterhin besteht ein statischer Phasenoffset $\Delta\varphi21$ bzw. $\Delta\varphi31$ zwischen den Funkknoten F1 und F2 bzw. dem ersten Funkknoten F1 und Extrafunkknoten FE. Dieser ist für die weiteren Betrachtungen unkritisch und wird nur der Vollständigkeit halber erwähnt. Im Sinne der weiteren Betrachtungen werden die Frequenzen $f_p$, $f'_p$, $f''_p$ als gleich groß betrachtet. Es wird vorausgesetzt, dass entsprechende Frequenzoffsetkorrekturen (falls notwendig) durchgeführt werden.

In dem ersten Schritt S1 m=0, n=0,1,2 wird von dem ersten Funkknoten F1 mit Hilfe eines Aufwärtsmischers und dem Signal des Frequenzgenerators der Frequenz $f_p$ der Signalvektor V1(S1;m,n) in die Hochfrequenzlage umgesetzt. Es entsteht das zeitkontinuierliche Initialsignal TI mit einer ersten Trägerfrequenz $\omega_p$ (p=1) mit einem Signalvektor V1(S1;m,n), dass in das Ausbreitungsmedium PM ausgekoppelt wird.. Das Initialsignal TI nimmt zu den Zeitpunkten $T1=(n-1)\cdot T_{MU}+(m-1)\cdot T_{SF}$ den Wert TI(S1;m,n) an. Zur Veranschaulichung sei der Signalvektor V1(S1;m,n)=1, d.h. der erste Funkknoten F1 sendet ein Referenz-Signal mit einer Trägerfrequenz $\omega_p$ mit p=1 als Initialsignal TI.

Der zweite Funkknoten F2 der Zelle E1 und der Extraknoten FE bestimmen jeweils während eines ersten Empfangszeitraums im ersten Schritt S1 mit m=0, n=0,1,2 jeweils die Empfangsvektoren $R_2(S1,m,n)$ bzw. $R_3(S1;m,n)$ durch Mischung des empfangenen HF-Signals mit dem Signal des Frequenzgenerators der Frequenz $f'_p$ bzw. $f''_p$ das um $T_{offs,21}$ bzw. $T_{off,31}$ gegenüber dem Generatorsignal des ersten Funkknotens F1 zeitlich verschoben ist.

Die Lage der Empfangsvektoren $R_2(m,n)$ bzw. $R_3(m,n)$ in der komplexen Ebene wird zunächst durch die interne Zeitreferenz bzw. den jeweiligen Zeitgeber $Z(T2)$ bzw. $Z(T3)$ mit $T2=n \cdot T'_{MU}+m \cdot T'_{SF}$ bzw. $T3=n \cdot T''_{MU}+m \cdot T''_{SF}$ bestimmt.

Die entsprechenden Empfangsvektoren $R_2$ und $R_3$ reflektieren das Übertragungsverhalten relativ zum Initialsignal TI des ersten Funkknoten F1 der Zelle E1 und enthalten die Übertragungsfunktionen $G_{12}(j\omega)$ bzw. $G_{13}(j\omega)$ des Ausbreitungsmediums PM auf der Frequenz $\omega=2\pi \cdot f_p$ und die Zeit-und Phasenoffset $T_{offs,12}$ und $T_{offs,13}$ bzw. $A\varphi_{12}$ und $\Delta\varphi_{12}$.

Anhand des Empfangsvektors $R_2(m,n)$ wird unter Beachtung einer möglichen Parametrisierung über die Datenschnittstelle DS2 ein Basisband-Signalvektor $V_2$ mit Hilfe der Funktionseinheit $H_2$ entsprechend $V_2(m,n+3)=H_2(R_2(m,n),...)$ gebildet und als Signalvektor $V_2$ an die Sendeeinheit TX des zweiten Funkknoten F2 übermittelt.

In dem zweiten Schritt S2 m=0,n=3,4,5 wird von dem zweiten Funkknoten F2 der Zelle E1 aus dem ermittelten Basisbandvektor $V2(S2; m,n)$ mittels eines Mischers und dem Frequenzgenerator ein Sendesignal $TA(S2;m,n)$ mit der Frequenz $f'_p$ erzeugt und als Antwortsignal TA in das Ausbreitungsmedium PM ausgekoppelt.

Der Signalvektor $V2(S2;m,n)$ für m=0, n=3,4,5 wird dabei aus dem Empfangsvektor $R_2(S1;m,n)$ m=0, n=0,1,2 mit Hilfe der Funktion $H2(R_2(m,n),...)$ und somit zumindest aus einem Teil des Empfangsvektors $R_2$ gebildet. Mögliche Funktionen H für die Bildung des Antwortsignals $V2=H2(R_2)$ sind $H2(R_2)= R_2$, $H2(R_2)=\exp(j \cdot phase(R_2))$ bzw. $H2(R_2) =1/R_2$, $H2(R_2)=conj(R_2)$ und $H2(R_2)=\exp(-j \cdot phase(R_2))$.

Der erste Funkknoten F1 der Zelle E1 und der Extrafunkknoten FE bestimmen im Schritt S2 jeweils während eines zweiten Empfangszeitraums m=0, n=3,4,5 ein Empfangsvektor $R_1(S2;m,n)$ bzw. $R_3(S2;m,n)$ mit m=0,n=3,4,5, wobei die Lage des Empfangsvektors $R_l$ jeweils bezüglich der internen Zeitreferenz des jeweiligen Zeitgebers $Z(T1),Z(T2)$ bzw. $Z(T3)$ bewertet wird. Dazu werden die empfangen HF Signale der Frequenz $f'_p$ mit einem Mischer und dem jeweiligen Signal des jeweiligen Frequenzgenerators der Frequenz $f_p$ bzw. $f''_p$ in die Basisbandlage konvertiert.

Die entsprechenden Empfangsvektoren $R_1$ und $R_3$ reflektieren das Übertragungsverhalten relativ zum Antwortsignal TA des zweiten Funkknotens F2 der Zelle E1 und enthalten die Übertragungsfunktionen $G_{12}(j\omega)$ bzw. $G_{32}(j\omega)$ des Ausbreitungsmediums PM auf der Frequenz $\omega=2\pi \cdot f_p$ und die Zeit-und Phasenversatze $T_{offs,12}$ und $T_{offs,32}$ bzw. $\Delta\varphi_{12}$ und $\Delta\varphi_{32}$.

Entsprechend der Wahl der Funktion H2 im zweiten Funkknoten F2 der Zelle E1 zur Bildung des Vektors V2 können besondere Eigenschaften des Messergebnisses erreicht werden. Beispielsweise sind die entstehenden Empfangsvektoren $R_1(j\omega_p)$ für $H2(R_2)= R_2$, $H2(R_2)=\exp(j \cdot angle(R_2))$ unabhängig vom Zeitversatz und bilden die wesentlichen Eigenschaften der Umlaufkanaltransferfunktion (2WR) $G_{2WR}(j\omega)= G_{21}(j\omega) \cdot G_{12}(j\omega)$ zwischen den beiden Funkknoten F1 und F2 der Zelle E1 ab. Funkkanäle sind in der Regel reziprok, sodass gilt $G_{21}(j\omega)=G_{12}(j\omega)$.

Wird die Funktion H2 durch eine der Funktionen $H2(R_2)=1/R_2$, $H2(R_2)=conj(R_2)$ und $H2(R_2)=\exp(-j \cdot angle(R_2))$, so kann aus dem Messergebnis der Zeitversatz $T_{offs,12}$ ermittelt werden. Die Empfangsvektoren $R_3(m,n)$ werden durch die bereits eingeführten Transferfunktionen der Wegdifferenz und des akkumulierten Wegs bzw. durch Differenzen von Zeitversätzen bzw. akkumulierten Zeitversätzen und deren Kombinationen dominiert.

Ein Messzyklus, der im Ausführungsbeispiel einen ersten Schritt S1 und einen zweiten Schritt S2 umfasst, wird mehrfach wiederholt, wobei bei jeder Wiederholung, die Trägerfrequenzen $\omega_\rho$, $\omega'_p$ bzw. $\omega''_p$ innerhalb eines vorbestimmten Frequenzbereichs nach den entsprechenden Anforderungen ausgewählt wird. Im dargestellten Ausführungsbeispiel entspricht die Trägerfrequenz $\omega'_p$ des zweiten Funkknotens F2 und die Trägerfrequenz $\omega''_p$ des dritten Funkknotens der ersten Trägerfrequenz $\omega_p$ des ersten Funkknotens F1. Mit jedem Messzyklus wird m inkrementiert und $\omega_p$ entsprechend den Anforderungen ausgewählt. Im Falle eines Frequenz-Sweeps wird $\omega_p$ mit jedem Messzyklus um $\omega_{step}$ erhöht.

Zwischen der ersten Sendeaktivität und der ersten Empfangsaktivität bzw. vice versa liegt immer eine Schrittverzögerung $T_{SV}$, $T'_{SV}$ bzw. $T''_{SV}$. Hierdurch werden Einflüsse bzw. Störungen durch einen Einschwingvorgang der Funcknoten vermieden. Die Schrittverzögerung $T_{SV}$ ist entsprechend größer als eine Einschwingzeit. Gleichzeitig ist zu vermerken, dass die vorgestellten Beziehungen einen eingeschwungenen stationären Zustand voraussetzen. Deshalb werden diese stationären Bereiche des Messzyklus durch entsprechende Guard-Bereiche oder auch Schrittverzögerungen abgegrenzt. In den Übergangsbereichen $T_{SV}$ ermittelte Signalvektoren sind nur eingeschränkt im Sinne des Verfahrens verwendbar. Für den dargestellten Fall betrifft dies die Vektoren $R_1(m,n)$, $R_2(m,n)$, $R_3(m,n)$ mit n=0,3 für alle m.

Für die Umsetzung des Verfahrens gemäß dem dargestellten Ausführungsbeispiel wird mindestens ein gültiger Empfangsvektor pro Funkknoten der Zelle E1 pro Messzyklus benötigt und mindestens ein weiterer Empfangsvektor für jeden einbezogen, im Empfangsmodus arbeitenden Extraknoten FE .

Im Ergebnis des Messzyklus entsteht für jede Sende-Empfangsrichtung mindestens ein komplexer Signalvektor. Die Gesamtheit der Signalvektoren über die genutzten Frequenzen entsprechen einer diskreten Abtastung im Frequenzbereich. Diese wird weiterhin in einem Vektor $L_{ij}(j\omega)=[L_{ij}(j\omega_1),...,L_{ij}(j\omega_p)]^T$ ($^T$ steht für transponiert), wie in Figur 1 dargestellt, zusammengefasst, wobei i der Index des Funkknoten ist, der den Signalvektor empfangen hat und j der Index des Funkknoten der Zelle ist, der das zugehörig Sendesignal ausgesandt hat. Steht pro Frequenz und Empfangsvorgang und Link nur ein Empfangsvektor zur Verfügung, so ist im einfachsten Fall $L_{ij}(j\omega_p)=Ri(m,n)$, wobei m durch die zu nutzende Frequenz $\omega_p=2\pi \cdot f_p$ bestimmt ist und n den entsprechenden Vektor indiziert bei dem der Funkknoten Fj der Zelle E1 gleichzeitig das entsprechende Sendesignal gesendet hat.

Mit Hilfe einer Transformation in den Zeitbereich über eine iFFT (inversen Fouriertransformation) entsteht die entsprechende Impulsantwort.

Ist $T_{MU}$ ein ganzzahliges Vielfaches des iFFT Zeitfensters, so haben die Versätze der Schrittsteuerung keinen direkten Einfluss auf das Ergebnis der iFFT. Die ermittelten Empfangsvektoren $L_{ij}(j\omega)$ sind dann nur vom Übertragungsverhalten des Ausbreitungsmediums und dem Zeitversatz zwischen den beteiligten Knoten abhängig.

Sollte das Ausbreitungsverhalten durch einen Signalpfad dominiert werden, dann besitzt die Impulsantwort nur einen Spitzenwert. Die diesem Spitzenwert zugeordnete Zeit $T_{ij,meas}$ ist nur noch von der Gruppenlaufzeit des entsprechenden Weges und dem Zeitversatz zwischen den entsprechenden Funkknoten abhängig. Zur Darstellung der Zusammenhänge wird dieses Ausbreitungsverhalten im Mittelpunkt der weiteren Betrachtungen stehen. Es versteht sich, daß das Ausbreitungsverhalten in der Regel durch mehrere Wege beeinflusst wird. Entsprechend müssen diese mit Mehrwegeanalyseverfahren aus den Vektoren $L_{ij}(j\omega)$ extrahiert werden.

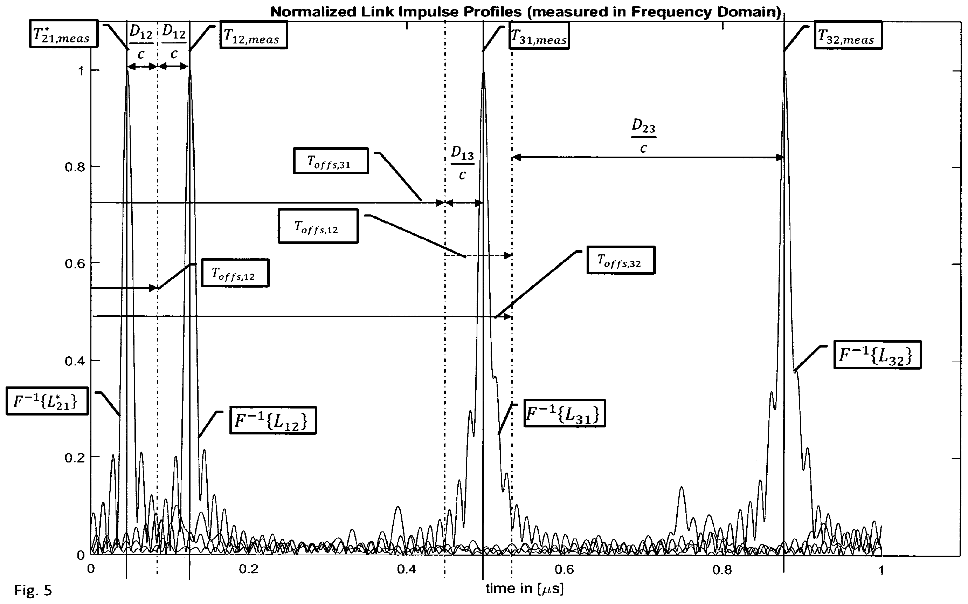

Figur 5 zeigt Messergebnisse der Funkknoten F1, F2 und FE für die erste Ausführungsform des erfindungsgemäßen Verfahrens für Funkmessanordnungen. Dargestellt sind die Impulsantworten im Zeitbereich, die mittels inverser Fouriertransformation $F^{-1}\{\}$ aus den Empfangsvektoren $F^{-1}\{L_{12}(j\omega)\}$, $F^{-1}\{L_{21}{}^*(j\omega)\}$, $F^{-1}\{L_{32}(j\omega)\}$, $F^{-1}\{L_{31}(j\omega)\}$ gewonnen wurden. Die zeitliche Position der entsprechenden Spitzenwerte $T_{12,meas}$, $T^*_{21,meas}$, $T_{32,meas}$ und $T_{31,meas}$ wurde ebenfalls markiert.

Für die den extrahierten Spitzenwerten zugeordnete Zeit $T_{ij,meas}$ gilt $T_{ij,meas}= T_i$-$T_j+D_{ij}/c$, wobei c die Lichtgeschwindigkeit darstellt. Mit dem Zeitversatz $T_{off,ij}$ wird $T_{ij,meas}=T_{offs,ij}+D_{ij}/c$ bzw. $T_{ij,meas}$ = -$T_{offs,ji}+D_{ij}/c$. Wählt man für die Transformation anstelle von $L_{ij}(j\omega)$ die konjugiert komplexe Darstellung $L_{ij}{}^*(j\omega)$ und transformiert sie in den Zeitbereich, so sind die entstehenden Impulsantworten symmetrisch zum Zeitversatz zwischen den beiden Funcknoten.

Aus den obigen Zusammenhängen lässt sich zeigen, dass $T_{12,meas}$ und $T^*_{21,meas}$ symmetrisch zum Zeitversatz $T_{offs,12}=(T_{12,meas}+ T^*_{21,meas})/2$ sind,. wobei die Differenz $T_{12,meas}$- $T_{offs,12}$ und $T_{offs,12}$ -$T^*_{21,meas}$ der Laufzeit $t_g=D_{21}/c$ entspricht, die für den Abstand $D_{12}$ benötigt wird. Der Abstands $T_{12,meas}$-$T^*_{21meas}$ entspricht der Umlaufzeit für den Weg von dem ersten Funkknoten F1 zu dem zweiten Funkknoten F2 und zurück, die auch als 2WR-Umlaufzeit bezeichnet wird und $2 \cdot D_{12}/c$ beträgt. Ein Messvorgang erlaubt also die Ermittlung des Abstandes und des Zeitversatzes zwischen den Funkknoten F1 und F2 der Zelle E1.

Die Messergebnisse $T_{32,meas}$ bzw. $T_{31,meas}$ befinden sich rechts von dem zugehörigen Zeitversatz $T_{offs,32}$ bzw. $T_{offs,31}$.

Die Nutzung der Messergebnisse $T_{32,meas}$ bzw. $T_{31,meas}$ zur Ermittlung von weiteren Zeitversätzen und Positionen soll jetzt erläutert werden. Dabei werden verschiedene Fälle betrachtet.

Fall A1: Ist dadurch gekennzeichnet, dass alle Abstände $D_{13}, D_{23}, D_{12}$ zwischen den Funkknoten F1,F2 und FE bekannt sind. Dann ergeben sich alle Zeitversätze $T_{offs,12} = T_{12,meas} - D_{12}/c$, $T_{offs,31}=T_{31,meas} - D_{13}/c$ und $T_{offs,32} = T_{32,meas}$-$D_{32}/c$. Da $D_{12}$ auch direkt aus den Messergebnissen extrahiert werde kann, muss dieser Wert nicht bekannt sein. Ein Vergleich des extrahierten Werts mit dem realen Wert für $D_{12}$ erlaubt die Ableitung von zusätzlichen Parametern, z.B. zur Qualitätskontrolle.

Diese Konfiguration erlaubt es die Zeitversätze von Extrafunkknoten FE, die nur im Empfangsmode arbeiten also nicht Teil der Zelle E1 sind und sich an einer bekannten Position befinden, zu ermitteln.

Fall B1: Besteht die Zelle E1 aus einem als Referenzfunkknoten arbeitenden ersten Funkknoten F1 mit einer bekannten Position P1 und einem als Tag arbeitenden zweiten Funkknoten F2, der mobil ist bzw. dessen Position nicht bekannt ist, so kann der Extraknoten FE als ein weiterer Referenzfunkknoten dienen, sofern der Extrafunkknoten FE an einer bekannten Position angeordnet ist.

In diesem Fall, ist $D_{13}$ bekannt, dann kann der Abstand $D_{12}$ sowie der Zeitversatz $T_{offs,12}$ direkt aus den Messungen $T^*_{21,meas}$ und $T_{12,meas}$ wie für Fall A1 bestimmt werden. Bei Kenntnis von $D_{13}=D_{31}$ lässt sich mit Hilfe von $T_{31,meas}$ der Zeitversatz $T_{offs,31} = T_{31,meas} - D_{31}/c$ bestimmen. Der Zeitversatz $T_{offs,32}$ ergibt sich über die Umlaufbedingung $T_{offs,32}= T_{offs,31} + T_{offs,12}$ zu $T_{offs,32}= (T_{31,meas} - D_{31}/c) + (T_{12,meas}+ T^*_{21,meas})/2$. Der Abstand $D_{23}$ ergibt sich mit Hilfe von $T_{32,meas}$ zu $D_{23}=c \cdot (T_{32,meas}$-$T_{offs,32})$ und damit zu $D_{23}=c \cdot (T_{32,meas}$-$(T_{31,meas} - D_{31}/c) - (T_{12,meas}+ T^*_{21,meas})/2)$. Damit ist es möglich innerhalb eines Messdurchlaufs zwei Abstände zum Tag-Funknoten, hier also dem zweiten Funcknoten F2 der Zelle E1, zu bestimmen und die Zeitversätze zwischen allen Knoten der Anordnung zu ermitteln.

Durch Bereitstellung von weiteren Extrafunkknoten FE, die ebenfalls nur in dem Empfangsmodus arbeiten, kann die Anzahl der Abstände, die innerhalb eines Messzyklus oder eines Messdurchgangs gemessen werden können, erweitert werden. Es entsteht pro Extrafunkknoten FE ein weiterer Distanz-Wert. Von großem Vorteil ist, dass die Anzahl der Schritte innerhalb eines Messzyklus nicht erweitert werden muss. Damit kann durch Hinzufügen von Extrafunkknoten FE die Messgeschwindigkeit signifikant erhöht werden.

Für eine Positionsbestimmung eines mobilen Funkknotens werden mindestens 3 Abstände zu verschiedenen positionsfesten Referenzknoten benötigt. In realen Ausbreitungsumgebungen sind eher 5 bis 6 Abstandsmessungen für eine zuverlässige Positionsermittlung notwendig, die beispielsweise mit einem positionsfesten Funkknoten F1 als Teil der Zelle E1 und fünf Extraknoten FE1, FE2, FE3, FE4 und FE5 mit bekannter Position in einem Messdurchgang gewonnen werden können.

Fall C1: In diesem Fall sind die beiden Funkknoten F1 und F2 der Zelle E1 beide an bekannten Positionen P1 bzw. P2 angeordnet und dienen damit als Referenzfunkknoten. Der Abstand $D_{12}$ ist somit bekannt. Aus den Messerwerten $T^*_{21,meas}$ und $T_{12,meas}$ kann zur Qualitätsbewertung auch $D_{12}$ bestimmt werden. Notwendig für den weiteren Ablauf ist die Ermittlung des $T_{offs,12}$. Diese erfolgt, wie in den vorherigen Beispielen beschrieben.

Eine direkte Ermittlung weiterer Abstände ist nicht möglich. Die Messergebnisse $T_{12,meas}$, $T^*_{21,meas}$, $T_{32,meas}$ und $T_{13,meas}$ können aber für die Ermittlung von Abstandsdifferenzen $D^3_{12(-)}=D_{31}-D_{32}$ verwendet werden. Es lässt sich zeigen, das sich die Abstandsdifferenz $D^3_{21(-)}=D_{32}-D_{31}$ aus den Messwerten errechnen lassen. Diese ergibt sich zum Beispiel aus $D^3_{21(-)}=c \cdot (T_{32,meas}-T_{31,meas}-T_{offs,12})$. Analog ist auch die Ableitung von akkumulierten Wegen möglich.

Mit der Ermittlung von Abstandsdifferenzen kann der Bogen zu Zeitdifferenzmessverfahren geschlossen werden.

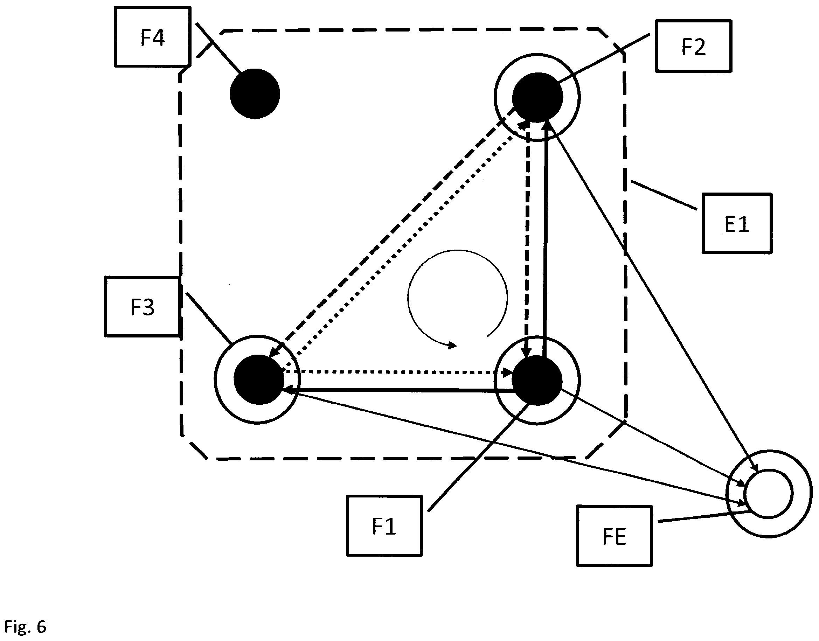

In der Figur 6 ist eine Erweiterung der Zelle E1 um weitere Referenzfuncknoten, nämlich um einen dritten Funkknoten F3 und einen vierten Funcknoten F4 dargestellt. Auch die weiteren Funkknoten F3 und F4 der Zelle E1 sind an bekannter Position angeordnet. Gemäß dem dargestellten Ausführungsbeispiel sind während eines Messzyklus nur drei der vier Funkknoten der Zelle E1 aktiv, wobei der Messzyklus aus drei Schritten S1, S2 und S3 besteht. Der vierte Funkknoten F4 der Zelle E1 ist zumindest während des dargestellten Messzyklus nicht aktiv.

In jedem Schritt arbeitet einer der drei aktiven Funkknoten der Zelle E1 in dem Sendemodus zum Senden des Initialsignal bzw. eines ersten Antwortsignals bzw. eines zweiten Antwortsignals. Die Funkknoten der Zelle E1 ermitteln jeweils Ihren Zeitversatz und übermitteln diesen über diesen via der Datenschnittstellen auch zu den mobilen Extrafuncknoten (Tag-Funkknoten), sodass die Extrafunkknoten mehrere Abstandsdifferenzen zu den verschiedenen Paaren von Funkknoten der Zelle E1 ermitteln und daraus über bekannte Algorithmen jeweils die Position bestimmen.

Die besondere Eigenschaft dieses Anwendungsfalls ist, dass mit einem begrenzten Satz an Referenzfunkknoten, die zusammen die Zelle E1 ausbilden, eine beliebige Anzahl von Extraknoten FE über Abstandsdifferenzen ihre Position ermitteln können. Diese Extraknoten FE müssen ausschließlich die entsprechenden Sendesignale empfangen und auswerten und erhalten die ermittelten Zeitversätze der Funkknoten der Zelle E1 über die jeweiligen Datenschnittstelle DS. Auch die Datenschnittstellen können jeweils drahtlos ausgebildet sein. Die Vorgehensweise erinnert an GPS Systeme. Im vorgestellten Verfahren müssen die Knoten der Zelle nicht aufwendig synchronisiert werden und benötigen auch keine hochstabilen Zeitreferenzen, wie die GPS Satelliten, um über Abstandsdifferenzen ihre jeweilige Position bestimmen zu können.

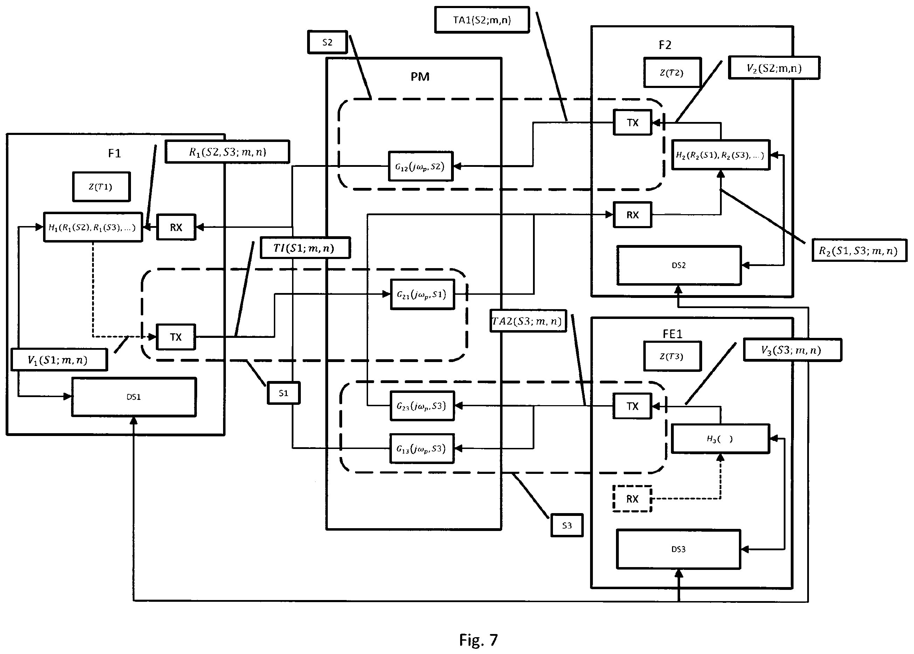

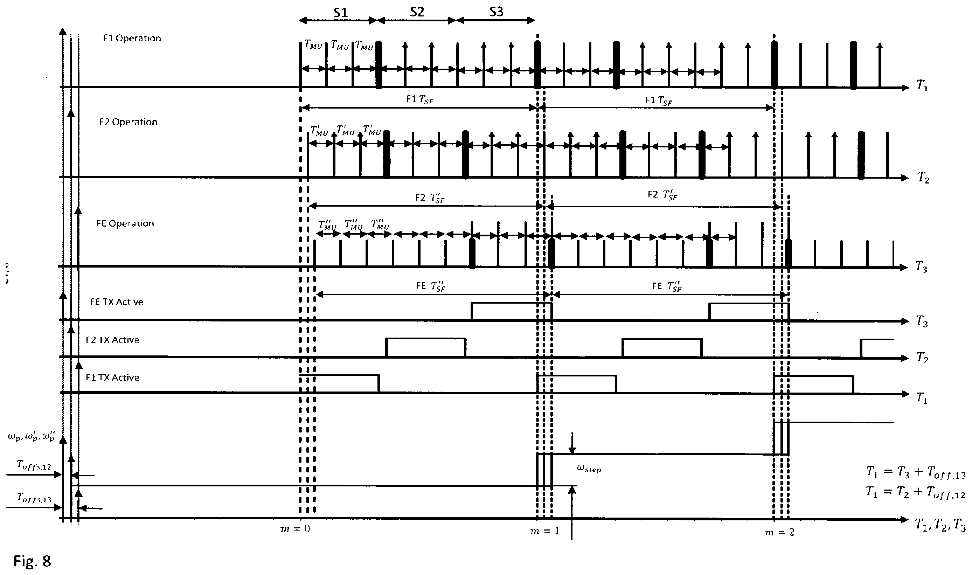

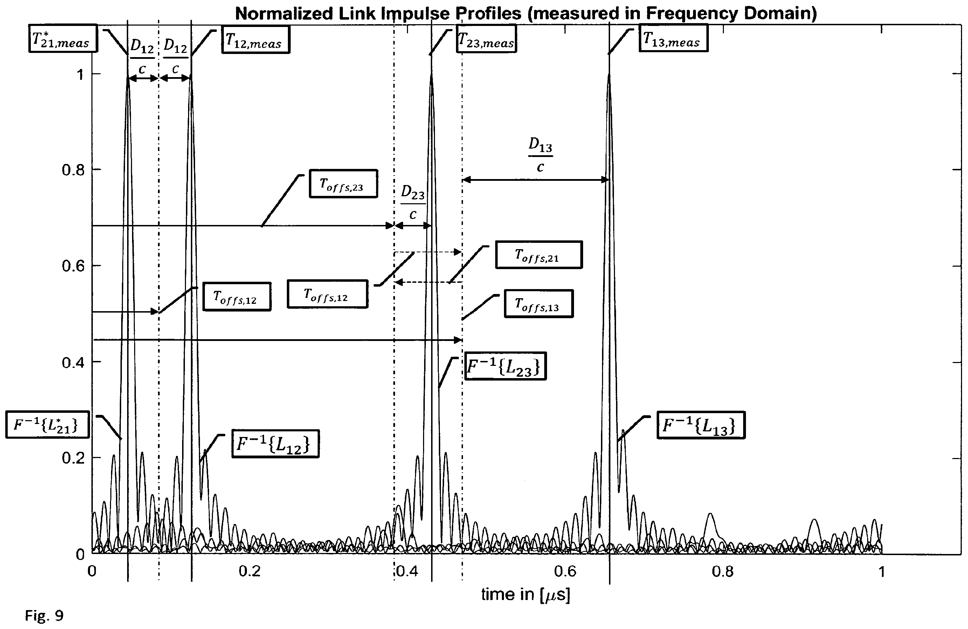

Gemäß einer zweiten Ausführungsform arbeitet der Extraknoten FE ausschließlich im Sendemodus, so ergeben sich einige Gemeinsamkeiten und Unterschiede. Die entsprechende Struktur der Anordnung von Funktionsblöcken ist in Figur 7 dargestellt. Figur 8 zeigt eine Form der Umsetzung in einem zeitlichen Ablaufdiagramm. In Figur 9 veranschaulicht an Hand von Messergebnissen die Zusammenhänge zwischen den ermittelten Impulsantworten. In der Folge werden die Unterschiede erläutert und die Vorteile der einzelnen Vorgehensweisen herausgearbeitet.

In dem dargestellten Ausführungsbeispiel verfügt der Extrafunkknoten über eine Sendeeinheit TX, eine Empfangseinheit ist optional bzw. wird nicht benötigt, da der Extrafunkknoten während des Messzyklus ausschließlich im Sendemodus arbeitet. Da sowohl die Funkknoten F1, F2 der Zelle E1 als auch der Extrafunkknoten FE abwechselnd Signale aussenden, erweitert sich der Messzyklus auf drei Schritte S1, S2 und S3. Die Reihenfolge in der die einzelnen Funkknoten F1, F2 und FE senden ist für das Verfahren von untergeordneter Bedeutung. Wie in den Figuren 7 und 8 dargestellt ist, sendet der erste Funkknoten F1 der Zelle E1 in dem Schritt S1, der zweite Funcknoten F2 der Zelle E1 sendet in dem Schritt S2 und der Extrafunkknoten F3 sendet in dem Schritt S3. In Figur 8 wurde deshalb der Messzyklus auf $n_{max}=9$ erweitert.

Es entstehen somit pro Schritt in den empfangenden Funkknoten insgesamt zwei Empfangsvektoren (im Schritt S1 für n=1, 2 im Schritt S2 für n=4, 5 und in Schritt S3 für n=7, 8).

Die Indexe/Zeitfenster n=0, 3, 6 sind für Systemübergänge und Einschwingvorgänge reserviert. Die Schritte S1 und S2 ähneln damit den Schritten S1 und S2 des in den Figuren 3, 4 und 5 dargestellten Verfahrens mit dem Unterschied, dass der Extraknoten FE während dieser Schritte keine Signale empfängt und damit seine Aktivitäten auf die Erhaltung des vorgegebenen Zeitverhaltens beschränkt. Im Schritt S3 sendet der Extraknoten FE einen Vektor V3(S3;m,n) mit Hilfe eines Frequenzgenerators, Aufwärtsmischers als Sendesignal TA2(S3;m,n) auf der jeweiligen Frequenz $\omega_p$.

Gemäß einer alternativen Ausführungsform modifiziert der Extraknoten FE den Vektor V3 gemäß Parametern, die der Extrafunkknoten FE über die Datenschnittstelle DS3 erhält. Solange die Parameter allen beteiligten Funcknoten bekannt sind, können alle Funknoten entsprechend Ihr Verhalten anpassen.

Alle bereits gemachten Aussagen zur Behandlung der Empfangsvektoren sind auch auf die Anordnung mit einem ausschließlich im Sendemodus arbeitenden Extrafunkknoten anwendbar. Im Zusammenhang mit ausschließlich sendenden Extraknoten ergeben sich andere Applikationseigenschaften. Die Grundzusammenhänge bleiben aber erhalten.

Figur 9 zeigt Messergebnisse der Funkknoten F1, F2 und FE für die zweite Ausführungsform des erfindungsgemäßen Verfahrens für Funkmessanordnungen. Dargestellt sind die Impulsantworten im Zeitbereich, die mittels inverser Fouriertransformation $F^{-1}\{\}$ aus den Empfangsvektoren $F^{-1}\{L_{12}(j\omega)\}$, $F^{-1}\{L_{21}{}^*(j\omega)\}$, $F^{-1}\{L_{23}(j\omega)\}$, $F^{-1}\{L_{13}(j\omega)\}$ gewonnen wurden. Die zeitliche Position der entsprechenden Spitzenwerte $T_{12,meas}$, $T^*_{21,meas}$, $T_{23,meas}$ und $T_{13,meas}$ wurde ebenfalls markiert.

Die Nutzung der Messergebnisse zur Unterstützung der Ermittlung von Zeitversätzen und Positionen soll jetzt erläutert werden. Dabei werden verschiedene Fälle betrachtet.

Fall A2: Sind alle Abstände $D_{13}$, $D_{23}$, $D_{12}$ bekannt, so lassen sich in der gleichen Vorgehensweise wie im Fall A1 direkt alle Zeitversätze $T_{offs,12}$, $T_{offs,13}$ und $T_{offs,23}$ bestimmen. Da $D_{12}$ auch direkt aus den Messergebnissen extrahiert werden kann, muss dieser Wert nicht bekannt sein. Ein Vergleich des extrahierten Werts mit dem realen Wert für $D_{12}$ erlaubt die Ableitung von zusätzlichen Parametern.

Diese Konfiguration erlaubt es die Zeitversätze von Extrafunkknoten FE, die nur im Sendemodus arbeiten, zu ermitteln.

Fall B2: Besteht die Zelle E1 aus einem ersten Funkknoten F1 mit bekannter Position und einem zweiten Funkknoten F2 mit nicht bekannter Position, dann kann der Extraknoten FE an einer bekannten Position angeordnet als ein Referenzfunkknoten dienen. In diesem Fall, ist $D_{13}$ bekannt und $D_{12}$ sowie der Zeitversatz $T_{offs,12}$ kann direkt aus den Messungen $T^*_{21,meas}$ und $T_{12,meas}$ bestimmt werden. Bei Kenntnis von $D_{13}$ lässt sich mit Hilfe von $T_{13,meas}$ der Zeitversatz $T_{offs,13}$ bestimmen. Der Zeitversatz $T_{offs,23}$ ergibt sich über die Umlaufbedingung $T_{offs,23}= T_{offs,13} - T_{offs,12}$. Der Abstand $D_{23}$ ergibt sich mit Hilfe von $T_{23,meas}$ zu $D_{23}=c\cdot(T_{23,meas}-T_{offs,23})$ entsprechend

$$D_{23}=c\cdot(T_{23,meas}- (T_{13,meas} - D_{13}/c)+ (T_{12,meas}+ T^*_{21,meas})/2).$$

Damit ist es möglich innerhalb eines Messdurchgangs zwei Abstände des zweiten Funkknotens F2 zu den weiteren Funkknoten zu bestimmen und die Zeitversätze zwischen allen Funkknoten der Anordnung zu ermitteln.

Durch Bereitstellung weiterer Extrafunkknoten FE, die jeweils ebenfalls im Sendemode arbeiten und jeweils an einer bekannten Position angeordnet sind, kann die Anzahl der Abstände, die innerhalb eines Messdurchgangs gemessen werden können, erweitert werden. Es entsteht pro Extrafunkknoten FE ein weiterer Distanz Wert. Da allerdings für jeden weiteren Extraknoten FE weitere Schritte innerhalb des Messzyklus eingeführt werden müssen, ist der Geschwindigkeitsgewinn für die Positionsermittlung gegenüber dem Fall B1 nur moderat.

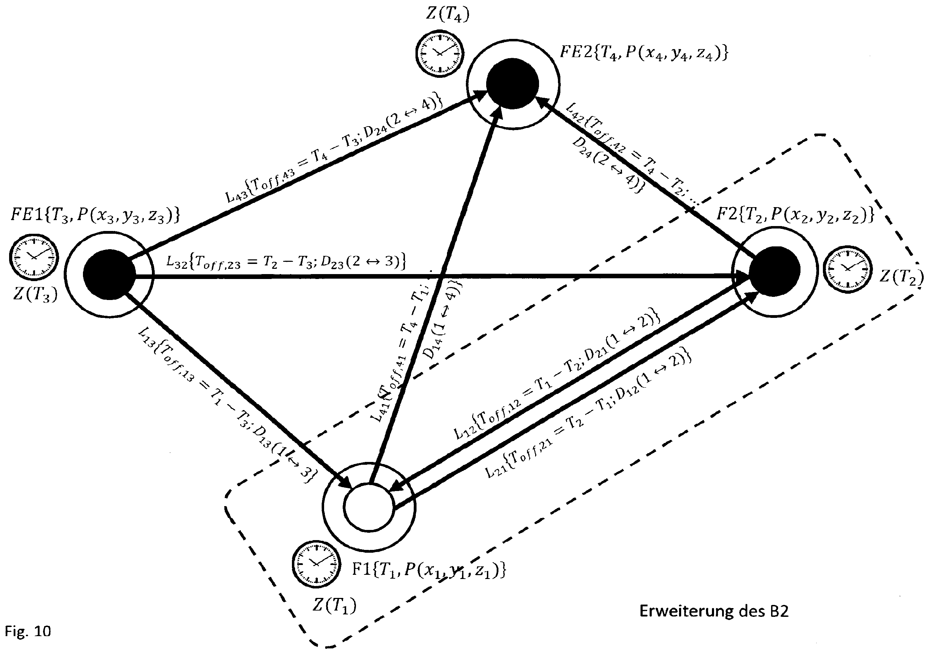

In der Figur 10 ist diese Ausführungsvariante für einen zweiten Extrafuncknoten FE2 dargestellt, wobei der zweite Extrafunkknoten FE2 wie der erste Extrafunkknoten FE1 an einer bekannten Position angeordnet ist, aber im Unterschied zu dem Extrafunkknoten FE1 ausschließlich im Empfangsmodus arbeitet. Zur Veranschaulichung sind die Funkknoten, deren Position bekannt ist, durch einen schwarz gefüllten Kreis dargestellt.

Fall C2: In diesem Fall sind die beiden Funkknoten F1 und F2 der Zelle E1 jeweils an einer bekannten Position angeordnet und dienen damit als Referenzfunkknoten. Der Abstand $D_{12}$ ist bekannt und kann zusätzlich z.B. zur Qualitätsbewertung aus den Messergebnissen ermittelt werden. Aus den Messwerten $T^*_{21,meas}$ und $T_{12,meas}$ wird zunächst der Zeitversatz $T_{offs,12}$ ermittelt. Eine direkte Ermittlung weiterer Abstände ist nicht möglich. Die Messergebnisse $T_{12,meas}$, $T^*_{21,meas}$, $T_{23,meas}$ und $T_{13,meas}$ können aber für die Ermittlung von Abstandsdifferenzen $D^3_{12(-)}=D_{13}-D_{23}$ verwendet werden. Es lässt sich zeigen, dass sich die Abstandsdifferenz $D^3_{12(-)}=D_{13}-D_{23}$ aus den Messwerten errechnen lässt. Diese ergibt sich zum Beispiel entsprechend unter C1 dargestellten Vorgehensweise als

$$D^3_{12(-)}=c\cdot(T_{13,meas} -T_{23,meas} -(T_{12,meas} +T^*_{21,meas})/2)$$

Analog ist auch die Ableitung von akkumulierten Wegen möglich. Mit der Ermittlung von Abstandsdifferenzen kann der Bogen zu Zeitdifferenzmessverfahren geschlossen werden.

Erweitert man jetzt die Zelle E1 um weitere jeweils an bekannter Position angeordnete Funkknoten (Referenzfunkknoten), die im laufenden Betrieb untereinander die Serien von Messzyklen durchführen und außerdem die Sendesignal der Extrafunkknoten FE auswerten, dann kann die Anzahl der gemessen Abstände pro Zeiteinheit erhöht werden. Letztlich benötigen alle Funkknoten, die im Sendemodus arbeiten ein Sendezeitfenster. Der zu erwartende Geschwindigkeitsgewinn bei Erweiterung der Zelle E1 ist daher eher moderat.

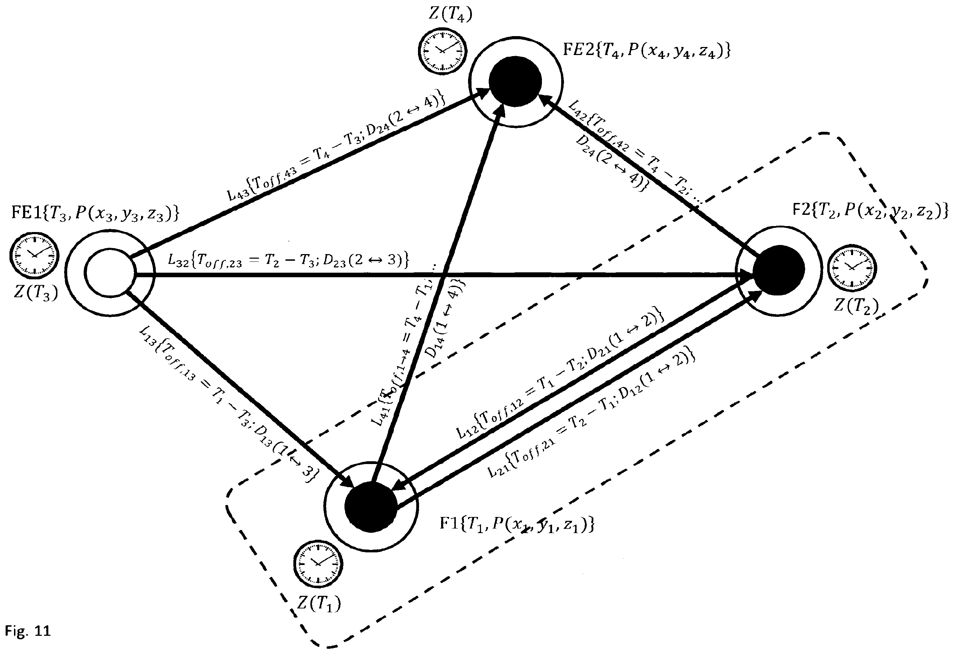

Fall D2: Dieser ist eine Erweiterung des Falls C2 im Sinne der Erweiterung der Anordnung um zusätzliche Extrafunkknoten, wie sie in Figur 11 dargestellt ist, wobei die zusätzlichen Extrafunkknoten jeweils ausschließlich im Empfangsmodus arbeiten und jeweils an bekannter Position angeordnet sind und damit als Referenzknoten dienen. Zur Veranschaulichung sind die Funcknoten, deren Position bekannt ist, durch einen schwarz gefüllten Kreis dargestellt.

Die ermittelten Empfangssignale übermitteln die zusätzlichen Extrafunkknoten über die jeweilige Datenschnittstelle an die anderen Funkknoten und/oder eine Recheneinheit. Gemäß den Zusammenhängen im Fall A1 und A2 lassen sich, bei bekannten Abständen unter den Referenzfunknoten alle Zeitversätze bestimmen. Das bedeutet, dass man eine Anordnung mit einem Tag-Knoten (ausschließlich im Sendemodus arbeitender erster Extrafunknoten FE) und den beiden Funknoten F1 und F2 der Zelle E1, um eine freie Anzahl von weiteren, ausschließlich im Empfangsmodus arbeitenden Extraknoten FE erweitern kann, wenn die weiteren Extraknoten FE ihrer Ergebnisse über die Datenschnittstellen mit allen anderen Funknoten austauschen. Die Anzahl der gleichzeitig ermittelbaren Abstandsdifferenzen erhöht sich stark, da mit jedem hinzugefügten Extrafunknoten FE die Anzahl der zusätzlich verfügbaren links durch die Anzahl der vorhandenen Funknoten bestimmt wird. Theoretisch kann so mit einem Messdurchgang eine beliebige Anzahl von Abstandsdifferenzen ermittelt werden. Praktisch relevant für eine Positionsermittlung sind 5 bis 6 Abstandsdifferenzen.

Es versteht sich, dass eine Transformation vom Frequenzbereich in den Zeitbereich aufwändig ist.

Die vorgestellten Operationen zur Ermittlung von Abständen, Abstandsdifferenzen und Zeitversätzen unter Nutzung von $T_{12,meas}$, $T^*_{21,meas}$, $T_{23,meas}$ und $T^*_{13,meas}$ beinhalten im Wesentlich Vektor- Addition, Vektor-Subtraktion, sowie Skalarmultiplikation von Vektoren. Diese Operationen sollten zweckmäßigerweise zuerst im Frequenzbereich durchgeführt werden, da eine Transformation vom Frequenzbereich in den Zeitbereich einen hohen Rechenaufwand erfordert und in der Regel eine größere Anzahl an Stützstellen erzeugt. (Die iFFT ist auch zur Interpolation hilfreich.) Diese erhöhte Punktanzahl muss dann entsprechend auch verarbeitet werden.

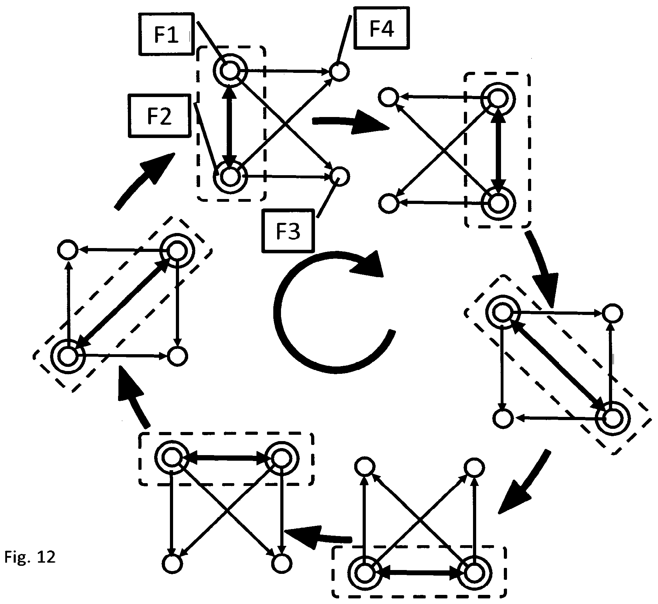

In der Figur 12 ist eine weitere erfindungsgemäße Ausführungsform des Verfahrens für Funkmessanwendungen dargestellt.

Es werden vier ortsfeste Funknoten F1, F2, F3 und F4 bereitgestellt, wobei jeder Funknoten über eine Sendeeinheit TX, eine Empfangseinheit RX, einen Zeitgeber verfügt.

Nacheinander bilden immer zwei der vier Funknoten F1, F2, F3 und F4 die Zelle E1 und tauschen im Rahmen eines Messzyklus ein Initialsignal $T_I$ und ein Antwortsignal $T_A$ aus, wobei die verbleibenden beiden Funknoten während dieses Messzyklus als Extrafunknoten FE ausschließlich in dem Empfangsmodus arbeiten und das Initialsignal $T_I$ sowie das Antwortsignal $T_A$ empfangen.

Diese Ausführungsform kann beispielsweise zur Selbstkalibration genutzt werden.

Mit der dargestellten Ausführungsform ist es außerdem möglich, den Raum zwischen den ortsfesten Funknoten zu überwachen. Durch eine Mehrwegeanalyse der empfangenen Signale kann beispielsweise der Zustand eines Raums (leer, belegt) festgestellt werden. Die Mehrwegeanalyse ermöglicht außerdem die Lokalisierung von sich bewegenden Objekten bzw. die Identifikation von Bewegungen in einem Raum zwischen den Funknoten.

Auch diese Ausführungsform kann durch weitere ausschließlich im Empfangsmodus arbeitende Extraknoten als weitere Referenzknoten erweitert werden.

**Patentansprüche**

**1.** Verfahren für Funkmessanwendungen mit wenigstens drei Funknoten, wobei

- während eines Messzyklus mindestens zwei Funknoten eine Zelle bilden und mindestens ein weiterer Funknoten ein Extrafunknoten ist,
- wobei der Messzyklus wenigstens zwei Schritte umfasst,
- während des Messzyklus mindestens zwei Funknoten der Zelle mindestens einmal in einem der wenigstens zwei Schritte in einem Sendemodus und mindestens einmal in einem der wenigstens zwei Schritte in einem Empfangsmodus arbeiten,
- während des Messzyklus der mindestens eine Extrafunknoten ausschließlich in einem Empfangsmodus oder ausschließlich in einem Sendemodus arbeitet,
- jeder Funknoten jeweils einen eigenen Zeitgeber, einen Signalprozessor, wenigstens eine Antenne und eine weitere Datenschnittstelle für den Datentransfer aufweist,
- zwischen den Zeitgebern jeweils ein Zeitversatz besteht,
- während jedes Messzyklus zumindest alle Sendesignale der Funknoten der Zelle zueinander kohärent sind,
- zum Eröffnen des Messzyklus in einem ersten Schritt von einem der Funknoten in dem Sendemodus das Initialsignal mit einer ersten Trägerfrequenz ausgesandt und zumindest von mindestens einem Funknoten der Zelle in dem Empfangsmodus empfangen wird,
- während des Messzyklus in mindestens einem weiteren Schritt mindestens ein Funknoten der Zelle von dem Empfangsmodus in den Sendemodus wechselt, das Antwortsignal mit einer weiteren Trägerfrequenz aussendet und das Antwortsignal von mindestens einem Funknoten der Zelle in dem Empfangsmodus empfangen wird,
- während des Messzyklus der mindestens eine Extrafunknoten mindestens ein Signal sendet oder mindestens ein Signal empfängt,
- wenigstens zwei Messzyklen auf verschieden Trägerfrequenzen ausgeführt werden,
**dadurch gekennzeichnet, dass**

- in einem Schritt jeweils nur ein Funkknoten sendet, wobei das Senden und Empfangen des Initialsignals bzw. des mindestens einen Antwortsignals wechselseitig erfolgt, wobei jeder Funkknoten die Lage des Empfangssignals jeweils in der komplexen Ebene bezüglich des eigenen Zeitgebers bewertet;
- das Verfahren in einem ersten Modus arbeitet, wobei
- in dem ersten Modus jedes Antwortsignal von dem in den Sendemodus wechselnden Funkknoten der Zelle zumindest aus einem Teil des empfangenen Initialsignals gebildet und mindestens eine Transferfunktion anhand der empfangenen Antwortsignale ermittelt wird, wobei
- in dem ersten Modus jeweils von dem in den Sendemodus wechselnden Funkknoten aus dem empfangenen Initialsignal ein komplexer Signalvektor ermittelt und das zu sendende Antwortsignal aus dem komplexen Signalvektor oder aus dem Reziproken des komplexen Signalvektors gebildet wird.

2. Verfahren nach Anspruch 1, **dadurch gekennzeichnet, dass** in der Zelle mindestens drei Funkknoten bereitgestellt werden, wobei jeder der mindestens drei Funkknoten in mindestens einem Schritt sendet und in allen weiteren Schritten empfängt, wobei in jedem Schritt nur ein einziger Funkknoten sendet.

3. Verfahren nach Anspruch 1 oder 2, **dadurch gekennzeichnet, dass**
alle Funkknoten der Zelle dazu ausgelegt sind, in einem Empfangsmodus und in einem Sendemodus zu arbeiten und während mindestens eines Messzyklus mindestens einer der Funkknoten der Zelle weder im Sendemodus und noch im Empfangsmodus arbeitet.

4. Verfahren nach einem der Ansprüche 1 bis 3, **dadurch gekennzeichnet, dass**
mehrere Extrafunkknoten bereitgestellt werden.

5. Verfahren nach Anspruch 4, **dadurch gekennzeichnet, dass** mittels mehrerer Messzyklen die Position eines der Funkknoten innerhalb der Zelle ermittelt wird.

6. Verfahren nach Anspruch 4, **dadurch gekennzeichnet, dass** mittels mehrerer Messzyklen die Position eines der Extrafunkknoten ermittelt wird.

7. Verfahren nach einem der vorangegangenen Ansprüche,
**dadurch gekennzeichnet, dass**
ein Messdurchgang aus mehreren Wiederholungen des Messzyklus gebildet wird und mindestens ein erster Funkknoten in mindestens einem ersten Messdurchgang Teil der Zelle ist und in mindestens einem weiteren Messdurchgang als Extrafunkknoten arbeitet und/oder mindestens ein weiterer Funkknoten in mindestens einem ersten Messdurchgang als Extrafunkknoten arbeitet und in mindestens einem weiteren Messdurchgang Teil der Zelle ist.

8. Verfahren nach einem der vorangegangenen Ansprüche,
**dadurch gekennzeichnet, dass**
alle Funkknoten an einer vorgegebenen Position angeordnet sind und aus den Transferfunktionen die Zeitversätze zwischen den Funkknoten ermittelt werden.

9. Verfahren nach einem der vorangegangenen Ansprüche,
**dadurch gekennzeichnet, dass**
ein Messdurchgang aus mehreren Wiederholungen des Messzyklus gebildet wird und zumindest die Sendesignale der Funkknoten der Zelle jeweils mindestens während eines Messdurchgangs oder mindestens während mehrere Messdurchgänge kohärent sind.

10. Verfahren nach einem der vorangegangenen Ansprüche,
**dadurch gekennzeichnet, dass**
ein Messdurchgang von mehreren Wiederholungen des Messzyklus gebildet wird und die erste Trägerfrequenz für jede Wiederholung während des Messdurchgangs jeweils einen vorbestimmten Wert innerhalb des Frequenzbereichs annimmt.

11. Verfahren nach einem der vorangegangenen Ansprüche,
**dadurch gekennzeichnet, dass**
jede weitere Trägerfrequenz der ersten Trägerfrequenz entspricht oder sich von der ersten Trägerfrequenz unterscheidet.

**EP 3 643 104 B2**

12. Verfahren nach einem der vorangegangenen Ansprüche,
**dadurch gekennzeichnet, dass**
bei jeder Wiederholung des Messzyklus zusätzlich zu der Trägerfrequenz des Antwortsignals eine Amplitude und/oder eine Phase des Antwortsignals verändert wird.

**Claims**

1. Method for radio measuring applications with at least three radio nodes, wherein

   - during a measuring cycle at least two radio nodes form a cell and at least one further radio node is an extra radio node,
   - wherein the measuring cycle comprises at least two steps,
   - during the measuring cycle at least two radio nodes of the cell operate at least once in one of the at least two steps in a transmitting mode and at least once in one of the at least two steps in a receiving mode,
   - during the measuring cycle the at least one extra radio node operates exclusively in a receiving mode or exclusively in a transmitting mode,
   - each radio node respectively comprises an individual time transmitter, a signal processor, at least one antenna and a further data interface for a data transfer,
   - a respective offset in time is present between the time transmitters,
   - during each measuring cycle at least all transmitting signals of the radio nodes of the cell are coherent with respect to one another,
   - for initiation of the measuring cycle in a first step the initial signal is transmitted at a first carrier frequency by one of the radio nodes in the transmitting mode and is received by at least one radio node of the cell in the receiving mode,
   - during the measuring cycle in at least one further step at least one radio node of the cell changes from the receiving mode to the transmitting mode, transmits the response signal at a further carrier frequency and the response signal is received by at least one radio node of the cell in the receiving mode,
   - during the measuring cycle the at least one extra radio node transmits at least one signal or receives at least one signal,
   - at least two measuring cycles are performed on different carrier frequencies,
   **characterised in that**
   - only one radio node transmits in each step, wherein the transmission and reception of the initial signal and the at least one response signal, respectively, takes place alternately, wherein each radio node evaluates the position of the reception signal respectively in the complex plane with respect to the individual time transmitter;
   - the method operates in a first mode, wherein
   - in the first mode each response signal is formed by the radio node, which is changing to the transmitting mode, of the cell at least from a part of the received initial signal and at least one transfer function is determined on the basis of the received response signals, wherein
   - in the first mode in each instance a complex signal vector is determined by the radio node, which is changing to the transmitting mode, from the received initial signal and the response signal to be transmitted is formed from the complex signal vector or from the reciprocal of the complex signal vector.

2. Method according to claim **1, characterised in that** at least three radio nodes are provided in the cell, wherein each of the at least three radio nodes transmits in at least one step and receives in all further steps, wherein in each step only a single one of the radio nodes transmits.

3. Method according to claim 1 or **2, characterised in that**
   all radio nodes of the cell are designed for the purpose of operating in a receiving mode and in a transmitting mode and during at least one measuring cycle at least one of the radio nodes of the cell operates neither in the transmitting mode nor in the receiving mode.

4. Method according to any one of claims 1 to **3, characterised in that**
   a plurality of extra radio nodes is provided.

5. Method according to claim **4, characterised in that** the position of one of the radio nodes within the cell is determined by means of a plurality of measuring cycles.

6. Method according to claim **4, characterised in that** the position of one of the extra radio nodes is determined by means of a plurality of measuring cycles.

7. Method according to any one of the preceding claims, **characterised in that**
a measuring round is formed from a plurality of repetitions of the measuring cycle and at least one first radio node in at least a first measuring round is part of the cell and in at least one further measuring round operates as an extra radio node and/or at least one further radio node operates in at least one first measuring round as an extra radio node and in at least one further measuring round is part of the cell.

8. Method according to any one of the preceding claims, **characterised in that**
all radio nodes are arranged at a predetermined position and the time offsets between the radio nodes are determined from the transfer functions.

9. Method according to one or more any one of the preceding claims, **characterised in that**
a measuring round is formed from a plurality of repetitions of the measuring cycle and at least the transmission signals of the radio nodes of the cell are respectively coherent at least during a measuring round or at least during a plurality of measuring rounds.

10. Method according to any one of the preceding claims, **characterised in that**
a measuring round is formed from a plurality of repetitions of the measuring cycle and the first carrier frequency adopts for each repetition during the measuring round a respective predetermined value within the frequency range.

11. Method according to any one of the preceding claims, **characterised in that**
each further carrier frequency corresponds with the first carrier frequency or differs from the first carrier frequency.

12. Method according to any one of the preceding claims, **characterised in that**
for each repetition of the measuring cycle in addition to the carrier frequency of the response signal an amplitude and/or a phase of the response signal is changed.

**Revendications**

1. Procédé pour des applications de mesure radio avec au moins trois nœuds radio, dans lequel

- pendant un cycle de mesure, au moins deux nœuds radio constituent une cellule et au moins un autre nœud radio est un nœud radio supplémentaire,
- dans lequel le cycle de mesure comprend au moins deux étapes,
- pendant le cycle de mesure, au moins deux nœuds radio de la cellule fonctionnent au moins une fois dans une desdites au moins deux étapes dans un mode d'émission et au moins une fois dans une desdites au moins deux étapes dans un mode de réception,
- pendant le cycle de mesure, ledit au moins un nœud radio supplémentaire fonctionne exclusivement dans un mode de réception ou exclusivement dans un mode d'émission,
- chaque nœud radio présente respectivement un temporisateur propre, un processeur de signal, au moins une antenne ainsi qu'une autre interface de données pour le transfert de données,
- un décalage temporel est respectivement présent entre les temporisateurs,
- pendant chaque cycle de mesure, au moins la totalité des signaux d'émission des nœuds radio de la cellule sont cohérents les uns par rapport aux autres,
- pour l'ouverture du cycle de mesure dans une première étape, le signal initial est émis avec une première fréquence porteuse par un des nœuds radio dans le mode d'émission et est reçu au moins par au moins un nœud radio de la cellule dans le mode de réception,
- pendant le cycle de mesure dans au moins une autre étape, au moins un nœud radio de la cellule passe du mode de réception dans le mode d'émission, émet le signal de réponse avec une autre fréquence porteuse et le signal de réponse est reçu par au moins un nœud radio de la cellule dans le mode de réception,
- pendant le cycle de mesure, ledit au moins un nœud radio supplémentaire émet au moins un signal ou reçoit au moins un signal,
- au moins deux cycles de mesure sont exécutés sur des fréquences porteuses différentes, **caractérisé en ce que**
- un seul nœud radio émet à chaque étape, dans lequel la transmission et la réception du signal initial et dudit au moins un signal de réponse ont lieu alternativement, dans lequel chaque nœud radio évalue la position du signal de réception respectivement dans le plan complexe par rapport au temporisateur propre ;
- le procédé fonctionne dans un premier mode, dans lequel
- dans le premier mode, chaque signal de réponse en provenance du nœud radio de la cellule qui passe dans le mode d'émission est constitué au moins d'une partie du signal initial reçu et au moins une fonction de transfert est déterminée sur la base des signaux de réponse reçus, dans lequel
- dans le premier mode, un vecteur de signal complexe est déterminé respectivement par le nœud radio qui passe dans le mode d'émission à partir du signal initial reçu et le signal de réponse à émettre est constitué du vecteur de signal complexe ou de la réciproque du vecteur de signal complexe.

2. Procédé selon la revendication 1, **caractérisé en ce qu'**au moins trois nœuds radio sont prévus dans la cellule, dans lequel chacun desdits au moins trois nœuds radio émet dans au moins une étape et reçoit dans toutes les autres étapes, dans lequel dans chaque étape un seul nœud radio émet.

3. Procédé selon la revendication 1 ou 2, **caractérisé en ce que**
la totalité des nœuds radio de la cellule sont configurés de manière à fonctionner dans un mode de réception et dans un mode d'émission et, pendant au moins un cycle de mesure, au moins un des nœuds radio de la cellule ne fonctionne ni dans le mode d'émission ni dans le mode de réception.

4. Procédé selon l'une quelconque des revendications 1 à 3, **caractérisé en ce que**
plusieurs nœuds radio supplémentaires sont prévus.

5. Procédé selon la revendication 4, **caractérisé en ce que** la position de l'un des nœuds radio à l'intérieur de la cellule est déterminée à l'aide de plusieurs cycles de mesure.

6. Procédé selon la revendication 4, **caractérisé en ce que** la position de l'un des nœuds radio supplémentaires est déterminée à l'aide de plusieurs cycles de mesure.

7. Procédé selon l'une quelconque des revendications précédentes, **caractérisé en ce qu'**un passage de mesure est constitué de plusieurs répétitions du cycle de mesure et au moins un premier nœud radio dans au moins un premier passage de mesure fait partie de la cellule et dans au moins un autre passage de mesure fonctionne en tant que nœud radio supplémentaire et/ou au moins un autre nœud radio dans au moins un premier passage de mesure fonctionne en tant que nœud radio supplémentaire et dans au moins un autre passage de mesure fait partie de la cellule.

8. Procédé selon l'une quelconque des revendications précédentes, **caractérisé en ce que**
la totalité des nœuds radio sont disposés dans une position prédéfinie et les décalages temporels entre les nœuds radio sont déterminés à partir des fonctions de transfert.

9. Procédé selon l'une quelconque des revendications précédentes, **caractérisé en ce qu'**un passage de mesure est constitué de plusieurs répétitions du cycle de mesure et au moins les signaux d'émission des nœuds radio de la cellule sont cohérents respectivement au moins pendant un passage de mesure ou au moins pendant plusieurs passages de mesure.

10. Procédé selon l'une quelconque des revendications précédentes, **caractérisé en ce qu'**un passage de mesure est constitué par plusieurs répétitions du cycle de mesure et la première fréquence porteuse pour chaque répétition pendant le passage de mesure adopte respectivement une valeur prédéfinie à l'intérieur de la plage de fréquences.

11. Procédé selon l'une quelconque des revendications précédentes, **caractérisé en ce que**
chaque autre fréquence porteuse correspond à la première fréquence porteuse ou est différente de la première fréquence porteuse.

12. Procédé selon l'une quelconque des revendications précédentes, **caractérisé en ce que**,
pour chaque répétition du cycle de mesure, une amplitude et/ou une phase du signal de réponse est (sont) modifiée(s) en plus de la fréquence porteuse du signal de réponse.

Fig. 1

Fig. 2

ZFS2

PD

$V_2(m,n)$

$H_2(R_2, \dots)$

$R_2(m,n)$

$e^{j\omega_p' \cdot T_2 + \Delta\varphi}$

$mit\ T_2 = T_1 - T_{offs,21}$

$e^{-j\omega_p' T_{SV}'}$

(−)

(+)

F2

DS2

PM

$TA(m,n)$

$G_{12}(j\omega_p')$

S2

S1

$G_{21}(j\omega_p)$

$TI(m,n)$

$e^{-j\omega_p T_{SV}}$

$e^{j\omega_p T_1}$

(−)

(+)

PD

$R_1(m,n)$

$H_1(R_1, \dots)$

$V_1(m,n)$

F1

DS1

ZFS1

Fig. 3

Fig. 4

**Normalized Link Impulse Profiles (measured in Frequency Domain)**

Fig. 5

time in [$\mu$s]

EP 3 643 104 B2

Fig. 6

Fig. 7

F1 Operation

F2 Operation

FE Operation

FE TX Active

F2 TX Active

F1 TX Active

$T_1$

$T_2$

$T_3$

$T_3$

$T_2$

$T_1$

$T_1 = T_3 + T_{off,13}$

$T_1 = T_2 + T_{off,12}$

$T_1, T_2, T_3$

$m = 2$

$m = 1$

$m = 0$

$\omega_{step}$

$F1\,T_{SF}$

$F2\,T'_{SF}$

$FE\,T''_{SF}$

$F1\,T_{SF}$

$F2\,T'_{SF}$

$FE\,T''_{SF}$

$T_{MU}\ T_{MU}\ T_{MU}$

$T'_{MU}\ T'_{MU}\ T'_{MU}$

$T''_{MU}\ T''_{MU}\ T''_{MU}$

S1 S2 S3

$\omega_p, \omega'_p, \omega''_p$

$T_{offs,12}$

$T_{offs,13}$

Fig. 8

26

Normalized Link Impulse Profiles (measured in Frequency Domain)

$T_{13,meas}$

$T_{23,meas}$

$T_{12,meas}$

$T_{21,meas}^{*}$

$\dfrac{D_{13}}{c}$

$\dfrac{D_{23}}{c}$

$\dfrac{D_{12}}{c}$  $\dfrac{D_{12}}{c}$

$T_{offs,21}$

$T_{offs,13}$

$T_{offs,23}$

$T_{offs,12}$

$T_{offs,12}$

$F^{-1}\{L_{13}\}$

$F^{-1}\{L_{23}\}$

$F^{-1}\{L_{12}\}$

$F^{-1}\{L_{21}\}$

time in [$\mu S$]

Fig. 9

Fig. 10

Erweiterung des B2

Fig. 11

Fig. 12

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 3243812 A
- DE 102009060505 B4
- DE 102009060593 A1
- DE 102009592 B4
- WO 0201247 A2
- US 20090149198 A1
- DE 102009060591 A1
- WO 2005119379 A1